# EUROPEAN PATENT APPLICATION

(11) **EP 1 526 646 A2**
(43) Date of publication of application: **27.04.2005**
(21) Application number: 04024892.4
(22) Date of filing: 20.10.2004
(51) Int. Cl.: H03M 7/40

(54) **arithmetic decoding/encoding device with parallel symbolcoding and context number calculation of next symbol**

(30) Priority: 22.10.2003 JP 2003361913
(71) Applicant: MATSUSHITA ELECTRIC INDUSTRIAL CO., LTD., Kadoma-shi, Osaka 571-8501 (JP)
(72) Inventor: Fuchigami, Ikuo, Kasuya-Gun Fukuoka-Ken, 811-2304 (JP); Kataoka, Tomonori, Oonojyo-Shi Fukuoka-Ken, 816-0983 (JP); Toida, Hiroaki, Kadoma-Shi Osaka, 571-0071 (JP); Nishida, Hideshi, Nishinomiya-Shi Hyogo-Ken, 662-0862 (JP)
(74) Representative: Pautex Schneider, Nicole

(57) **Abstract**

An arithmetic decoding device (100) comprises an adaptive arithmetic decoding unit (110), a context calculating unit (120), and a decoding control unit (130).The adaptive arithmetic decoding unit (110) includes an arithmetic decoding unit (111), a symbol appearing probability control unit (114), and a probability state storing unit (115). When a variable-length encoded code (VLC) is inputted, the context calculating unit (120) generates a context number from a classification and a decoded bit number of a syntax element of the inputted code, and outputs the context number to the adaptive arithmetic decoding unit (110). The adaptive arithmetic decoding unit (110) renews a symbol appearing probability based on the frequency of appearance of the symbol, thereby arithmetic-decoding the inputted code (VLC), and feeding output data (OD). The decoding control unit (130) controls the whole arithmetic decoding device (100).

## Description

The present invention relates to an arithmetic encoding/decoding device used for moving picture encoding and decoding, and especially an arithmetic encoding/decoding device based on CABAC (Context-based Adaptive Binary Arithmetic Coding), described in the moving picture encoding standard H.264.

As variable length encoding in compression encoding of a moving picture, entropy encoding is used. Arithmetic encoding belongs to the entropy encoding.

ITU-T (International Telecommunication Union-Telecommunication Standardization Sector) has established H. 264 as standard. Arithmetic encoding is introduced as a method of variable length encoding in the standard. (See reference 1: Joint Video Team (JVT) of ISO/IEC MPEG & ITU-T VCEG; "Draft ITU-T Recommendation and Final Draft International Standard of Joint Video Specification (ITU-T Rec. H. 264|ISO/IEC 14496-10 MPEG-AVC))

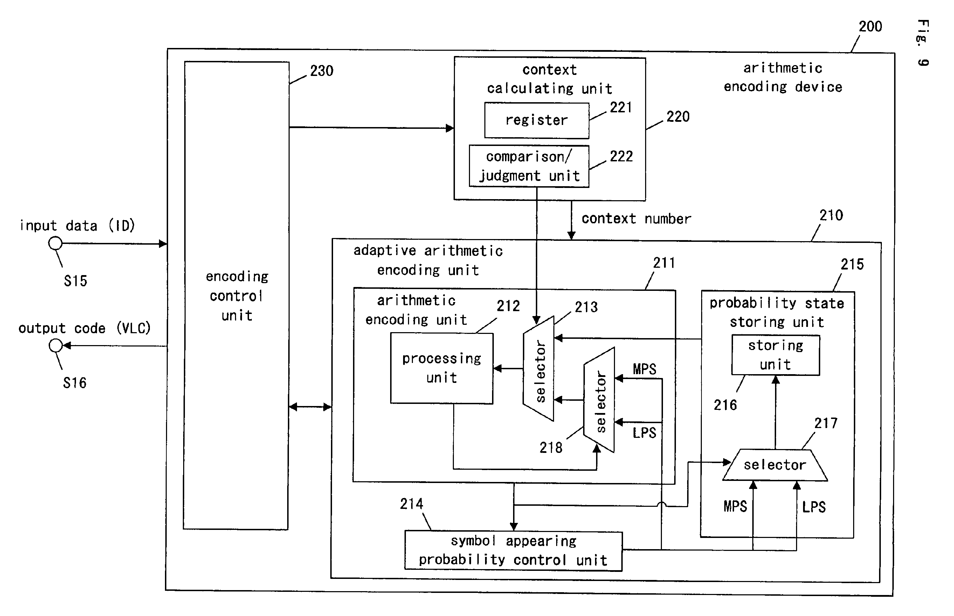

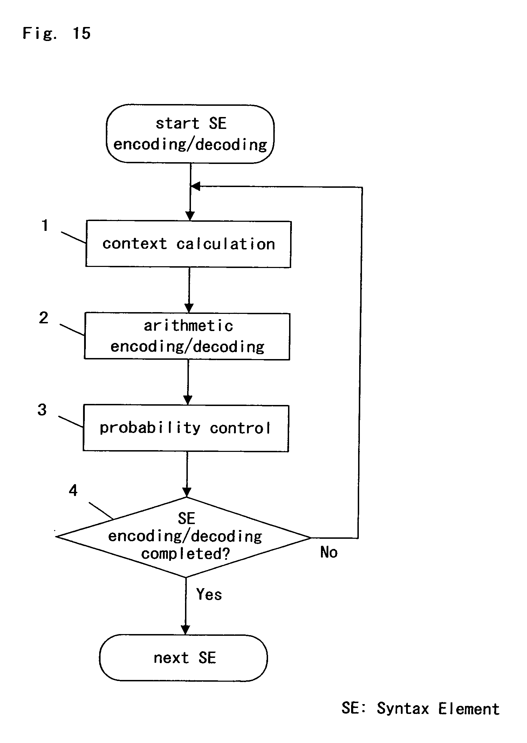

Fig. 15 is a flowchart of a process for the arithmetic encoding/decoding in accordance with the ITU-T standard H.264. Fig 15 is a re-edited version of Fig. 9-1 of the reference 1, focusing on functions.

The flow of arithmetic encoding/decoding process is explained in the following using Fig. 15.

When encoding or decoding starts for one syntax element (SE), context calculation is performed for the syntax element in Step 1. In the context calculation, a context number corresponding to the context is obtained, and a set of a symbol value and probability state is obtained by the context number. Even though there are some exceptions, the symbol value is mainly obtained referring to a cross-reference table, and the probability state is obtained referring to a value stored in Step 3 mentioned in the following. The obtained set of the symbol value and probability state is given to an arithmetic encoding/decoding process, and the process moves to Step 2.

In Step 2, the arithmetic encoding or decoding of the concerned syntax is performed using the set of the symbol value and probability state, received in Step 1, and the result is outputted as an output signal. Simultaneously, the information of the encoded or decoded symbol is outputted to a symbol appearing probability control process, and the process moves to Step 3.

In Step 3, after receiving the information of the encoded or decoded symbol, a renewed set of a symbol value and probability state, which will be used at the next processing, is obtained, and the renewed set is stored as a probability state.

In Step 4, it is judged whether or not the encoding or decoding of the concerned syntax element has been completed. If the encoding or decoding is not completed, the process goes back to Step 1, and the same process is repeated until the encoding or decoding is completed. When the encoding or decoding of the concerned syntax element is completed, the following syntax element is processed.

As described above, the process of the arithmetic encoding and decoding is established by the ITU-T standard H.264; however, a practical realization method is entrusted to the device manufacturer.

An object of the present invention is to provide an arithmetic encoding/decoding device with a high-speed processing capability, as the practical realization method of the process of the arithmetic encoding and decoding that is established by the ITU-T standard H.264

A first aspect of the present invention provides an arithmetic decoding device comprising: an arithmetic decoding unit operable to decode an encoded moving picture inputted, thereby outputting a decoded symbol as a result of decoding; a context calculating unit operable to calculate a context number for the encoded moving picture, thereby feeding the calculated context number to the arithmetic decoding unit; a symbol appearing probability control unit operable to renew a set of a symbol value and a symbol appearing probability for one of a most probable symbol and a least probable symbol, based on the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic decoding unit decodes an n-th code of the encoded moving picture, the context calculating unit is operable in parallel to calculate the context number of an (n+1)-th code of the encoded moving picture, the (n+1)-th code being next to the n-th code, where n is a natural number.

According to the present structure, while one inputted code is decoded, a context for a next inputted code that follows the one inputted code can be obtained. Therefore, after the completion of decoding for one inputted code, decoding for the next inputted code can be immediately performed. Therefore, improvement in speed of the decoding can be attained.

A second aspect of the present invention provides an arithmetic decoding device comprising: an arithmetic decoding unit operable to decode an encoded moving picture inputted, thereby outputting a decoded symbol as a result of decoding; a context calculating unit operable to calculate a context number for the encoded moving picture, thereby feeding the calculated context number to the arithmetic decoding unit; a symbol appearing probability control unit operable to renew a set of a symbol value and a symbol appearing probability for one of a most probable symbol and a least probable symbol, based on the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic decoding unit decodes a code of the encoded moving picture, the symbol appearing probability control unit is operable in parallel to calculate two kinds of renewed values for the set of the symbol value and the symbol appearing probability for the code, one of the two kinds of the renewed values being for a case when the arithmetic decoding unit decodes a most probable symbol and the other of the two kinds of the renewed values being for a case when the arithmetic decoding unit decodes a least probable symbol, and the symbol appearing probability control unit is operable to select more suited one of the two kinds of the renewed values after the arithmetic decoding unit determines the decoded symbol.

According to the present structure, while one code is decoded, sets of a symbol value and probability state are renewed for both cases where the decoded symbol is a most probable symbol and where the decoded symbol is a least probable symbol, and after the decoded symbol is determined, either one of the renewed sets can be chosen. As a result, acquiring a necessary set of the symbol value and probability state in decoding of the following code, decoding and writing to a probability state storing unit can be performed immediately; thereby the speed of the arithmetic decoding can be further improved.

A third aspect of the present invention provides the arithmetic decoding device as defined in the second aspect, wherein the symbol appearing probability control unit is operable to feed the arithmetic decoding unit the two kinds of the renewed values for the set of the symbol value and the symbol appearing probability, and wherein when the arithmetic decoding unit decodes an encoded moving picture with a same context number, the arithmetic decoding unit is operable, based on a symbol decoded immediately previously, to select more suited one of the two kinds of the renewed values.

According to the present structure, a symbol appearing probability control unit can give, in advance, an arithmetic decoding unit two kinds of renewed sets of a symbol value and probability state. When decoding data with the same context is performed, either one of the sets of the symbol value and probability state can be chosen as soon as the decoding result is acquired, and the decoding for the next code can be started; thereby the speed of the arithmetic decoding can be further improved.

A fourth aspect of the present invention provides the arithmetic decoding device as defined in the first aspect, wherein the probability state storing unit is operable to store the symbol appearing probability in terms of a probability state number.

According to the present structure, since the symbol appearing probability can be referred only by designating the probability state number, the efficiency of the process can be improved.

A fifth aspect of the present invention provides an arithmetic encoding device comprising: an arithmetic encoding unit operable to arithmetic-encode a moving picture signal inputted, thereby outputting an encoded symbol as a result of arithmetic encoding; a context calculating unit operable to calculate a context number for the moving picture signal, thereby feeding the calculated context number to the arithmetic encoding unit; a symbol appearing probability control unit operable to renew a set of a symbol value and a symbol appearing probability for one of a most probable symbol and a least probable symbol, based on the encoded symbol outputted by the arithmetic encoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes an n-th moving picture signal, the context calculating unit is operable in parallel to calculate the context number of an (n+1)-th moving picture signal, the (n+1)-th moving picture signal being next to the n-th moving picture signal, where n is a natural number.

According to the present structure, while one inputted data of a moving picture signal is encoded, a context for a next inputted data that follows the one inputted data can be obtained. Therefore, after the completion of encoding for one inputted data, encoding for the next inputted data can be immediately performed. Therefore, improvement in speed of the encoding can be attained.

A sixth aspect of the present invention provides an arithmetic encoding device comprising: an arithmetic encoding unit operable to arithmetic-encode a moving picture signal inputted, thereby outputting an encoded symbol as a result of arithmetic encoding; a context calculating unit operable to calculate a context number for the moving picture signal, thereby feeding the calculated context number to the arithmetic encoding unit; a symbol appearing probability control unit operable to renew a set of a symbol value and a symbol appearing probability for one of a most probable symbol and a least probable symbol, based on the encoded symbol outputted by the arithmetic encoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes a moving picture signal, the symbol appearing probability control unit is operable in parallel to calculate two kinds of renewed values for the set of the symbol value and the symbol appearing probability for the moving picture signal, one of the two kinds of the renewed values being for a case when the arithmetic encoding unit arithmetic-encodes a most probable symbol and the other of the two kinds of the renewed values being for a case when the arithmetic encoding unit arithmetic-encodes a least probable symbol, and the symbol appearing probability control unit is operable to select more suited one of the two kinds of the renewed values after the arithmetic encoding unit determines the encoded symbol.

According to the present structure, while one inputted data of a moving picture signal is encoded, sets of a symbol value and probability state are renewed for both cases where the encoded symbol is a most probable symbol and where the encoded symbol is a least probable symbol, and after the encoded symbol is determined, either one of the renewed sets can be chosen. As a result, acquiring a necessary set of the symbol value and probability state in encoding of the following data, encoding and writing to a probability state storing unit can be performed immediately; thereby the speed of the arithmetic encoding can be further improved.

A seventh aspect of the present invention provides the arithmetic encoding device as defined in the sixth aspect, wherein the symbol appearing probability control unit is operable to feed the arithmetic encoding unit the two kinds of the renewed values for the set of the symbol value and the symbol appearing probability, and wherein when the arithmetic encoding unit arithmetic-encodes a moving picture signal with a same context number, the arithmetic encoding unit is operable, based on a symbol encoded immediately previously, to select more suited one of the two kinds of the renewed values.

According to the present structure, a symbol appearing probability control unit can give, in advance, an arithmetic encoding unit two kinds of renewed sets of a symbol value and probability state. When encoding a next data with the same context is performed, either one of the sets of the symbol value and probability state can be chosen as soon as the encoding result is acquired, and the encoding for the next data can be started; thereby the speed of the arithmetic encoding can be further improved.

An eighth aspect of the present invention provides the arithmetic encoding device as defined in the fifth aspect, wherein the probability state storing unit is operable to store the symbol appearing probability in terms of a probability state number.

According to the present structure, since the symbol appearing probability can be referred only by designating the probability state number, the efficiency of the process can be improved.

A ninth aspect of the present invention provides an arithmetic encoding/decoding device comprising: an arithmetic encoding unit operable to arithmetic-encodes a moving picture signal inputted, thereby outputting an encoded symbol as a result of arithmetic encoding; an arithmetic decoding unit operable to decode an encoded moving picture inputted, thereby outputting a decoded symbol as a result of decoding; a context calculating unit operable to calculate a first context number for the moving picture signal, thereby feeding the first calculated context number to the arithmetic encoding unit, and the context calculating unit being further operable to calculate a second context number for the encoded moving picture, thereby feeding the second calculated context number to the arithmetic decoding unit; a symbol appearing probability control unit operable to renew a set of a symbol value and a symbol appearing probability for one of a most probable symbol and a least probable symbol, based on one of the encoded symbol outputted by the arithmetic encoding unit and the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes an m-th moving picture signal, the context calculating unit is operable in parallel to calculate the first context number of an (m+1)-th moving picture signal, the (m+1)-th moving picture being next to the m-th moving picture, where m is a natural number; and wherein, while the arithmetic decoding unit decodes an n-th code of the encoded moving picture, the context calculating unit is operable in parallel to calculate the second context number of an (n+1)-th code of the encoded moving picture, the (n+1)-th code being next to the n-th code, where n is a natural number.

According to the present structure, in encoding, while a current inputted data of a moving picture signal is encoded, a context for a next inputted data that follows the current inputted data can be obtained. Therefore, after the completion of encoding for the current inputted data, encoding for the next inputted data can be immediately performed. In decoding, while a current inputted code is decoded, a context for a next inputted code that follows the current inputted code can be obtained. Therefore, after the completion of decoding for the current inputted code, decoding for the next inputted code can be immediately performed. As a result, improvement in speed of the encoding/decoding can be attained. Therefore, improvement in speed of the can be attained.

A tenth aspect of the present invention provides an arithmetic encoding/decoding device comprising: an arithmetic encoding unit operable to arithmetic-encode a moving picture signal inputted, thereby outputting an encoded symbol as a result of arithmetic encoding; an arithmetic decoding unit operable to decode an encoded moving picture inputted, thereby outputting a decoded symbol as a result of decoding; a context calculating unit operable to calculate a first context number for the moving picture signal, thereby feeding the first context number to the arithmetic encoding unit, and the context calculating unit being further operable to calculate a second context number for the encoded moving picture, thereby feeding the second context number to the arithmetic decoding unit; a symbol appearing probability control unit operable to renew a set of a symbol value and a symbol appearing probability for one of a most probable symbol and a least probable symbol, based on one of the encoded symbol outputted by the arithmetic encoding unit and the decoded symbol outputted by the arithmetic decoding unit; and a probability state storing unit operable to store the set of the symbol value and the symbol appearing probability, the set being renewed by the symbol appearing probability control unit and indexed with the context number. While the arithmetic encoding unit arithmetic-encodes a moving picture signal, the symbol appearing probability control unit is operable in parallel to calculate two kinds of renewed values for the set of the symbol value and the symbol appearing probability for the moving picture signal, one of the two kinds of the renewed values being for a case when the arithmetic encoding unit arithmetic-encodes a most probable symbol and the other of the two kinds of the renewed values being for a case when the arithmetic encoding unit arithmetic-encodes a least probable symbol, and the symbol appearing probability control unit is operable to select more suited one of the two kinds of the renewed values after the arithmetic encoding unit determines the encoded symbol. On the other hand, while the arithmetic decoding unit decodes a code of the encoded moving picture, the symbol appearing probability control unit is operable in parallel to calculate two kinds of renewed values for the set of the symbol value and the symbol appearing probability for the code, one of the two kinds of the renewed values being for a case when the arithmetic decoding unit decodes a most probable symbol and the other of the two kinds of the renewed values being for a case when the arithmetic decoding unit decodes a least probable symbol, and the symbol appearing probability control unit is operable to select more suited one of the two kinds of the renewed values after the arithmetic decoding unit determines the decoded symbol.

According to the present structure, in encoding, while a certain inputted data of a moving picture signal is encoded, sets of a symbol value and probability state are renewed for both cases where the encoded symbol is a most probable symbol and where the encoded symbol is a least probable symbol, and after the encoded symbol is determined, either one of the renewed sets can be chosen. As a result, acquiring a necessary set of the symbol value and probability state in encoding of the following data, encoding and writing to a probability state storing unit can be performed immediately.

Furthermore, in decoding, while a certain code is decoded, sets of a symbol value and probability state are renewed for both cases where the decoded symbol is a most probable symbol and where the decoded symbol is a least probable symbol, and after the decoded symbol is determined, either one of the renewed sets can be chosen. As a result, acquiring a necessary set of the symbol value and probability state in decoding of the following code, decoding and writing to a probability state storing unit can be performed immediately. Thereby, the speed of the arithmetic encoding/decoding can be further improved.

An eleventh aspect of the present invention provides the arithmetic encoding/decoding device as defined in the tenth aspect, wherein the symbol appearing probability control unit is operable to feed the arithmetic encoding unit and the arithmetic decoding unit the two kinds of the renewed values for the set of the symbol value and the symbol appearing probability, wherein when the arithmetic encoding unit arithmetic-encodes a moving picture signal with a same first context number, the arithmetic encoding unit is operable, based on a symbol encoded immediately previously, to select more suited one of the two kinds of the renewed values, and wherein when the arithmetic decoding unit decodes an encoded moving picture with a same second context number, the arithmetic decoding unit is operable, based on a symbol decoded immediately previously, to select more suited one of the two kinds of the renewed values.

According to the present structure, a symbol appearing probability control unit can give, in advance, an arithmetic encoding unit (or arithmetic decoding unit) two kinds of renewed sets of a symbol value and probability state. When encoding (or decoding) data with the same context is performed, either one of the sets of the symbol value and probability state can be chosen as soon as the encoding (or decoding) result is acquired, and the encoding (or decoding) for the next data can be started; thereby the speed of the arithmetic encoding (or arithmetic decoding) can be further improved.

A twelfth aspect of the present invention provides the arithmetic encoding/decoding device as defined in the ninth aspect, wherein the probability state storing unit is operable to store the symbol appearing probability in terms of a probability state number.

According to the present structure, since the symbol appearing probability can be referred, in encoding and decoding, only by designating the probability state number, the efficiency of the encoding and decoding process can be improved.

A thirteenth aspect of the present invention provides a portable terminal device comprising: a receiver operable to receive an encoded moving picture; a moving picture expanding unit comprising an arithmetic decoding device, the moving picture expanding unit being operable to expand the encoded moving picture received by the receiver to generate a display image; and a picture display unit operable to display the display image. The arithmetic decoding device comprises: an arithmetic decoding unit operable to decode the encoded moving picture received by the receiver, thereby outputting a decoded symbol as a result of decoding; a context calculating unit operable to calculate a context number for the encoded moving picture, thereby feeding the calculated context number to the arithmetic decoding unit; a symbol appearing probability control unit operable to renew a set of a symbol value and a symbol appearing probability for one of a most probable symbol and a least probable symbol, based on the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic decoding unit decodes an n-th code of the encoded moving picture, the context calculating unit is operable in parallel to calculate the context number of an (n+1)-th code of the encoded moving picture, the (n+1)-th code being next to the n-th code, where n is a natural number.

According to the present structure, the arithmetic decoding can be performed at high speed by employing the moving picture expanding unit with higher efficiency. Thereby, reception and display of a high-quality moving picture become possible.

A fourteenth aspect of the present invention provides a portable terminal device comprising: a sender/receiver operable to send and receive an encoded moving picture; a camera operable to shoot a moving picture, thereby feeding a moving picture signal; a moving picture compressing/expanding unit comprising an arithmetic encoding/decoding device, the moving picture compressing/expanding unit being operable to process the moving picture signal fed by the camera to generate an encoded moving picture to be sent by the sender/receiver, and the moving picture compressing/expanding unit being further operable to process the encoded moving picture received by the sender/receiver to generate a display image; and a picture display unit operable to display the moving picture shot by the camera and the display image generated by the moving picture compressing/expanding unit. The arithmetic encoding/decoding device comprises: an arithmetic encoding unit operable to arithmetic-encode the moving picture signal fed by the camera, thereby outputting an encoded symbol as a result of arithmetic encoding; an arithmetic decoding unit operable to decode the encoded moving picture received by the sender/receiver, thereby outputting a decoded symbol as a result of decoding; a context calculating unit operable to calculate a first context number for the moving picture signal, thereby feeding the first context number to the arithmetic encoding unit, and the context calculating unit being further operable to calculate a second context number for the encoded moving picture, thereby feeding the second context number to the arithmetic decoding unit; a symbol appearing probability control unit operable to renew a set of a symbol value and a symbol appearing probability for one of a most probable symbol and a least probable symbol, based on one of the encoded symbol outputted by the arithmetic encoding unit and the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes an m-th moving picture signal, the context calculating unit is operable in parallel to calculate the first context number of an (m+1)-th moving picture signal, the (m+1)-th moving picture signal being next to the m-th moving picture signal, where m is a natural number; and wherein, while the arithmetic decoding unit decodes an n-th code of the encoded moving picture, the context calculating unit is operable in parallel to calculate the second context number of an (n+1)-th code of the encoded moving picture, the (n+1)-th code being next to the n-th code, where n is a natural number.

According to the present structure, the arithmetic encoding and decoding can be performed at high speed by employing the moving picture expanding unit with higher efficiency. Thereby, shooting, sending/receiving, and displaying a high-quality moving picture become possible.

A fifteen aspect of the present invention provides a moving picture shooting device comprising: a camera operable to shoot a moving picture, thereby feeding a moving picture signal; a recoding/replaying unit operable to record and replay an encoded moving picture; a moving picture compressing/expanding unit comprising an arithmetic encoding/decoding device, the moving picture compressing/expanding unit being operable to process the moving picture signal fed by the camera to generate an encoded moving picture to be recorded by the recoding/replaying unit, and the moving picture compressing/expanding unit being further operable to process the encoded moving picture replayed by the recoding/replaying unit to generate a display image; and a picture display unit operable to display the moving picture shot by the camera and the display image generated by the moving picture compressing/expanding unit. The arithmetic encoding/decoding device comprises: an arithmetic encoding unit operable to arithmetic-encode the moving picture signal fed by the camera, thereby outputting an encoded symbol as a result of arithmetic encoding; an arithmetic decoding unit operable to decode the encoded moving picture replayed by the recoding/replaying unit, thereby outputting a decoded symbol as a result of decoding; a context calculating unit operable to calculate a first context number for the moving picture signal, thereby feeding the first context number to the arithmetic encoding unit, and the context calculating unit being further operable to calculate a second context number for the encoded moving picture, thereby feeding the second context number to the arithmetic decoding unit; a symbol appearing probability control unit operable to renew a set of a symbol value and a symbol appearing probability for one of a most probable symbol and a least probable symbol, based on one of the encoded symbol outputted by the arithmetic encoding unit and the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes an m-th moving picture signal, the context calculating unit is operable in parallel to calculate the first context number of an (m+1)-th moving picture signal, the (m+1)-th moving picture signal being next to the m-th moving picture signal, where m is a natural number; and wherein, while the arithmetic decoding unit decodes an n-th code of the encoded moving picture, the context calculating unit is operable in parallel to calculate the second context number of an (n+1)-th code of the encoded moving picture, the (n+1)-th code being next to the n-th code, where n is a natural number.

According to the present structure, the arithmetic encoding and decoding can be performed at high speed by employing the moving picture expanding unit with higher efficiency. Thereby, shooting, recoding/replaying, and displaying a high-quality moving picture become possible.

A sixteenth aspect of the present invention provides a moving picture recoding/replaying device comprising: a moving picture input unit operable to input a first moving picture signal; a moving picture output unit operable to output a second moving picture signal; a recording/replaying unit operable to record a first encoded moving picture and replay a second encoded moving picture; and a moving picture compressing/expanding unit comprising an arithmetic encoding/decoding device, the ) moving picture compressing/expanding unit being operable to process the first moving picture signal inputted by the moving picture input unit, thereby generating the first encoded moving picture to be recorded by the recoding/replaying unit, and the moving picture compressing/expanding unit being further operable to process the second encoded moving picture replayed by the recoding/replaying unit, thereby generating the second moving picture signal to be outputted by the moving picture output unit. The arithmetic encoding/decoding device comprises: an arithmetic encoding unit operable to arithmetic-encode the first moving picture signal inputted by the moving picture input unit, thereby outputting the first encoded symbol as a result of arithmetic encoding; an arithmetic decoding unit operable to decode the second encoded moving picture replayed by the recoding/replaying unit, thereby generating the second moving picture signal as a result of decoding; a context calculating unit operable to calculate a first context number for the first moving picture signal, thereby feeding the first context number to the arithmetic encoding unit, and the context calculating unit being further operable to calculate a second context number for the second encoded moving picture, thereby feeding the second context number to the arithmetic decoding unit; a symbol appearing probability control unit operable to renew a set of a symbol value and a symbol appearing probability for one of a most probable symbol and a least probable symbol, based on one of the encoded symbol outputted by the arithmetic encoding unit and the decoded symbol outputted by the arithmetic decoding unit; and a probability state storing unit operable to store the set of the symbol value and the symbol appearing probability, the set being renewed by the symbol appearing probability control unit and indexed with the context number, wherein, while the arithmetic encoding unit arithmetic-encodes an m-th signal of the first moving picture signal, the context calculating unit is operable in parallel to calculate the first context number for an (m+1)-th signal of the first moving picture signal, the (m+1)-th signal being next to the m-th signal, where m is a natural number; and wherein, while the arithmetic decoding unit decodes an n-th code of the second encoded moving picture, the context calculating unit is operable in parallel to calculate the second context number of an (n+1)-th code of the second moving picture signal, the (n+1)-th code being next to the n-th code, where n is a natural number.

According to the present structure, the arithmetic encoding and decoding can be performed at high speed by employing the moving picture expanding unit with higher efficiency. Thereby, recoding/replaying a high-quality moving picture becomes possible.

The above, and other objects, features and advantages of the present invention will become apparent from the following description read in conjunction with the accompanying drawings, in which like reference numerals designate the same elements.
Fig. 1 is a block diagram of an arithmetic encoding/decoding device as a first examination example, which has realized the process of arithmetic encoding and decoding in accordance with the ITU-T standard H.264;
Fig. 2 is a timing chart of the first examination example;
Fig. 3 is a block diagram of an arithmetic decoding device in a first embodiment of the present invention;
Fig. 4 is a timing chart of the arithmetic decoding device in the first embodiment of the present invention;
Fig. 5 is a block diagram of an arithmetic decoding device in a second embodiment of the present invention;
Fig. 6 is a timing chart of the arithmetic decoding device in the second embodiment of the present invention;
Fig. 7 is a block diagram of an arithmetic encoding device in a third embodiment of the present invention;
Fig. 8 is a timing chart of the arithmetic encoding device in the third embodiment of the present invention;
Fig. 9 is a block diagram of an arithmetic encoding device in a fourth embodiment of the present invention;
Fig. 10 is the timing chart of the arithmetic encoding device in the fourth embodiment of the present invention;
Fig. 11 is a block diagram of an arithmetic encoding/decoding device in a fifth embodiment of the present invention;
Fig. 12 is a block diagram of a portable terminal device in a sixth embodiment of the present invention;
Fig. 13 is a block diagram of a moving picture shooting device in a seventh embodiment of the present invention;
Fig. 14 is a block diagram of a moving picture recording/replaying device in an eighth embodiment of the present invention; and
Fig. 15 is a flowchart of a process for arithmetic encoding/decoding in accordance with the ITU-T standard H.264.

Referring to the drawings, embodiments of the present invention will now be explained.

First, inventors of the present invention examined how to practically realize the process of the arithmetic encoding and decoding according to the ITU-T standard H.264 shown in reference 1.

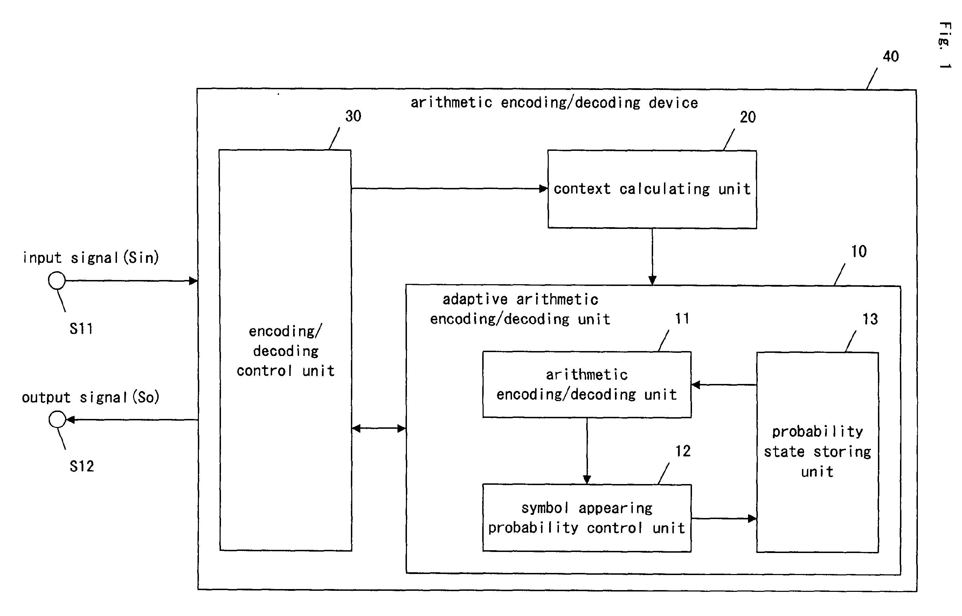

Fig. 1 is a block diagram of an arithmetic encoding/decoding device as a first examination example, which has realized the process of arithmetic encoding and decoding in accordance with the ITU-T standard H.264;

In Fig. 1, an arithmetic encoding/decoding device 40 of the first examination example comprises an adaptive arithmetic encoding/decoding unit 10, a context calculating unit 20, and an encoding/decoding control unit 30. The adaptive arithmetic encoding/decoding unit 10 includes an arithmetic encoding/decoding unit 11, a symbol appearing probability control unit 12, and a probability state storing unit 13.

The context calculating unit 20 generates a context number from a classification, an encoded bit number, or a decoded bit number of a syntax element (SE) of an input signal (Sin) S 11. (This processing corresponds to the processing of Step 1 of Fig. 15.)

According to the context number, the adaptive arithmetic encoding/decoding unit 10 performs the adaptive arithmetic encoding or decoding of the input signal (Sin) S11, and outputs an output signal (So) S12. (This processing corresponds to the processing of Step 2 of Fig. 15.)

More specifically, the probability state storing unit 13 stores a set of a symbol value and probability state for a most probable symbol for each context number. The probability state indicates an appearance probability of the symbol. The probability state storing unit 13 gives the arithmetic encoding/decoding unit 11 the set of the symbol value and probability state corresponding to the context number generated by the context calculating unit 20. The arithmetic encoding/decoding unit 11 performs the arithmetic encoding or decoding for the input signal (Sin) S11 by using the set of the symbol value and probability state, and outputs the output signal (So) S12. Simultaneously, the arithmetic encoding/decoding unit 11 gives the information of the symbol encoded or decoded, to the symbol appearing probability control unit 12.

The symbol appearing probability control unit 12 receives the information of the symbol encoded or decoded, obtains a renewed set of a symbol value and probability state that is to be used for the next encoding or decoding, and stores the renewed set into the probability state storing unit 13. (This processing corresponds to the processing of Step 3 of Fig. 15.)

In this way, if the arithmetic encoding/decoding device 40 of the present examination example is used, the process of arithmetic encoding and decoding in accordance with the ITU-T standard H.264 may be practiced.

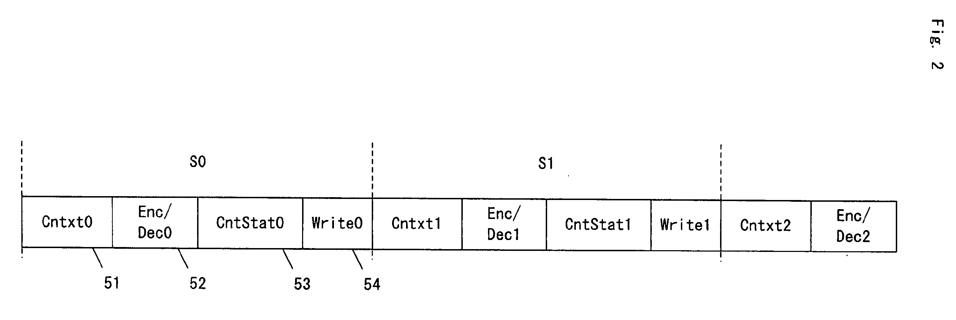

Fig. 2 is a timing chart of the first examination example.

An interval S0, where a first syntax element 0 is processed, is explained. The arithmetic encoding/decoding device 40 performs context calculation and reading of a probability state in processing 51 designated by "Contxt0", performs arithmetic encoding or decoding in processing 52 designated by "Enc/Dec0", performs symbol appearing probability control in processing 53 designated by "ContStat0", and performs writing of the probability state in processing 54 designated by "write0."

Also in an interval S1, where a following syntax element 1 is processed, the arithmetic encoding/decoding device 40 repeats the same processing as in the interval S0. Hereinafter, the same processing is performed for the following syntax elements.

As shown in Fig. 2, the arithmetic encoding/decoding device 40 of the present examination example needs to start each processing step after receiving the processing result of one step before, therefore, the processing becomes sequential, and time needed for one syntax element to be processed becomes the sum of the time of each processing. In other words, as shown in Fig. 2, the interval S0, which is necessary for processing of the syntax element 0, is the sum of the time that is spent for the processing 51, the processing 52, the processing 53, and the processing 54.

When there is a large amount of code (that is syntax element number) to be processed per time for encoding or decoding, reducing process time of encoding or decoding is essential. since the arithmetic encoding/decoding device 40 of the present examination example performs sequentially each step of processing, process time for each step must be reduced in order to reduce the entire process time. This fact clearly indicates that improvement in speed for the present examination example is limited at the present skill level.

Published Japanese Patent Application No. Hei 09-1351175 disclosed a prior art that deals with the subject. In the prior art, when there is no renewal of a probability state for a syntax element, writing to a probability state storing unit is omitted so that process time can be shorten. However, since the point that each processing is sequential does not differ from the present examination example, it is not enough as a measure for improvement in processing speed.

Based on the above consideration, the inventors of the present invention have completed the present invention with the new idea. In the following, the embodiments of the present invention are explained, referring to pertaining drawings.

### (First embodiment)

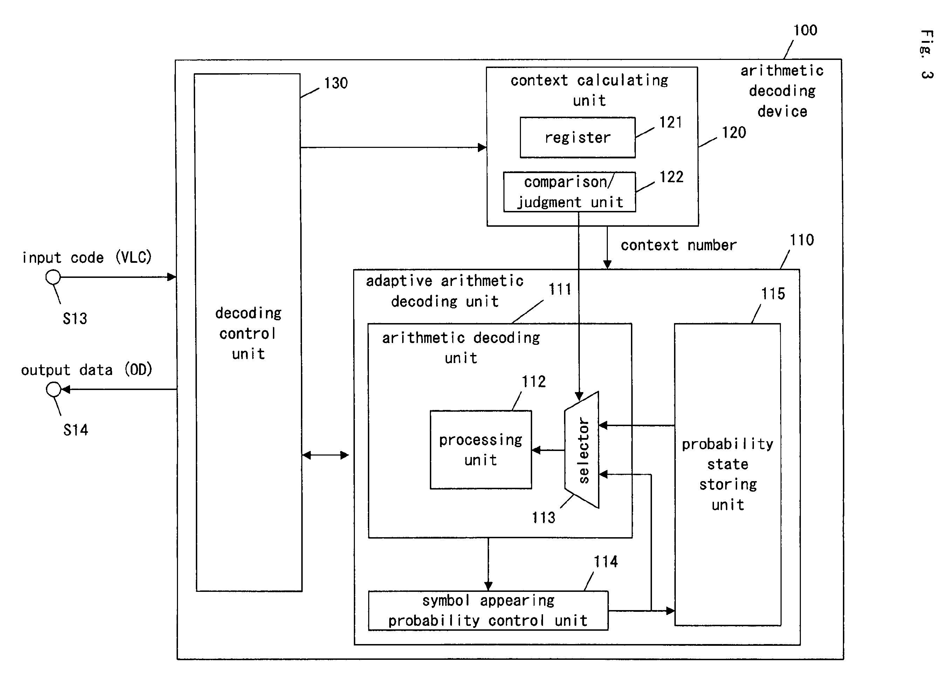

Fig. 3 is a block diagram of an arithmetic decoding device in a first embodiment of the present invention.

An arithmetic decoding device 100 of the present embodiment comprises an adaptive arithmetic decoding unit 110, a context calculating unit 120, and a decoding control unit 130. The adaptive arithmetic decoding unit 110 includes an arithmetic decoding unit 111 that includes a selector 113 and a processing unit 112, a symbol appearing probability control unit 114, and a probability state storing unit 115. The context calculating unit 120 includes a register 121 and a comparison/judgment unit 122.

The context calculating unit 120 generates a context number for an input code (VLC) S 13 of inputted variable-length code, according to the classification and the decoded bit number of the syntax element, and outputs the context number to the adaptive arithmetic decoding unit 110. The adaptive arithmetic decoding unit 110 adaptively changes symbol appearing probabilities according to frequency of symbol appearance, performs an arithmetic decoding for the input code (VLC) S 13, and outputs output data (OD) S14. The decoding control unit 130 entirely controls the arithmetic decoding device 100.

The operation of the adaptive arithmetic decoding unit 110 is explained more specifically in the following. The probability state storing unit 115 stores, for each context number, a set of a symbol value for a most probable symbol (or a least probable symbol) and a probability state that shows the appearance probability of the symbol. Based on the set of the symbol value and probability state that is read out from the probability state storing unit 115, the arithmetic decoding unit 111 performs the arithmetic decoding for the input code (VLC) S13, and outputs the output data (OD) S14. The symbol appearing probability control unit 114 receives the information of the symbol that is decoded by the arithmetic decoding unit 111, obtains a renewed set of a symbol value and probability state that is to be used for the next decoding, and writes the renewed set into the probability state storing unit 115.

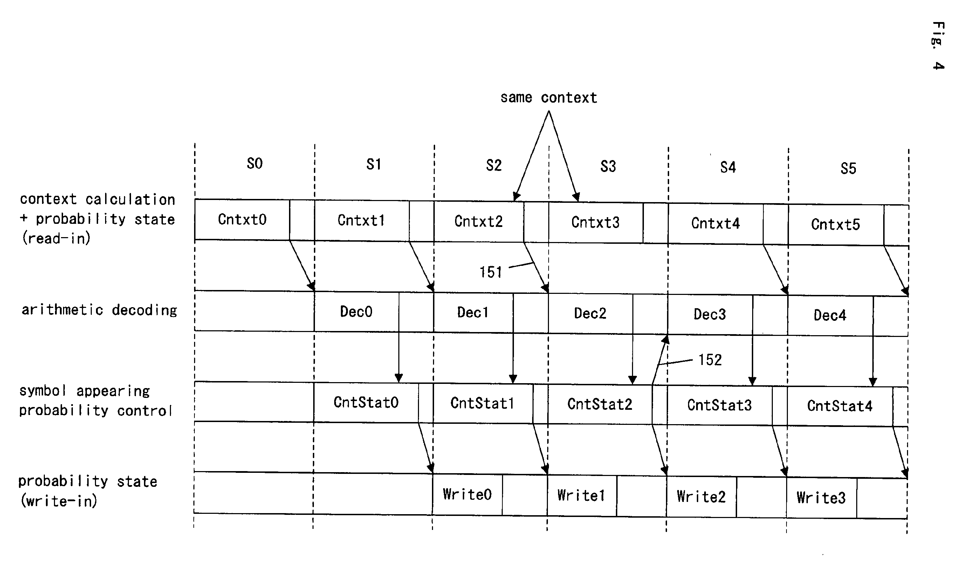

) Next, the flow of processing for the arithmetic decoding device 100 of the present embodiment is explained referring to Fig. 3 and Fig. 4.

Fig. 4 is a timing chart of the arithmetic decoding device in the first embodiment of the present invention

In Fig. 4, processing "Cntxt0" is executed in the first interval S0. In the processing "Cntxt0", the context calculating unit 120 generates a context number for the 0th symbol in connection with the syntax element for decoding, and sends the context number to the adaptive arithmetic decoding unit 110. The arithmetic decoding unit 111 reads out the set of the symbol value and probability state corresponding to the context number that is sent from the probability state storing unit 115.

In the next interval S1, processing "Cntxt1", processing "Dec0", and processing "CntStat0" are executed.

In the processing "Dec0", the arithmetic decoding unit 111 performs the arithmetic decoding for the 0th input code (VLC) S 13, according to the set of the symbol value and probability state, which is for the previous symbol and read out from the probability state storing unit 115, and outputs the decoded value as the output data (OD) S14. Simultaneously, the arithmetic decoding unit 111 gives the decoded symbol information to the symbol appearing probability control unit 114.

In the processing "CntStat0", after the interval S1 starts and before the decoded symbol is determined, the symbol appearing probability control unit 114 calculates renewed sets of a symbol value and probability state for the 0th symbol. Each of the renewed sets is respectively for the cases where the decoded symbol is a most probable symbol and a least probable symbol. The symbol appearing probability control unit 114 chooses either one of the renewed sets and outputs the chosen one as the renewed value after the decoded symbol is determined.

In the interval S1, in parallel with the processing "Dec0" and the processing "CntStat0", the processing "Cntxt1" for the 1 st symbol that is the next input is executed and a corresponding context number is generated.

In the next interval S2, processing "Cntxt2", processing "Dec1 ", processing "CntStat1 ", and processing "WRITE0" are executed in parallel.

In the processing "WRITEO", the symbol appearing probability control unit 114 writes, into the probability state storing unit 115, the renewed set of the symbol value and probability state of the decoded symbol for the 0th symbol, which has been chosen in the interval S 1.

In the interval S2, the processing "Dec1" and the processing "CntStat1", which are executed in parallel, are the processing for the 1 st input code (VLC) S 13, and what is done in the processing is the same as in the processing "Dec0" and the processing "CntStat0", which are executed in the interval S1. In the interval S2, the processing "Cntxt2" executed in parallel is the processing for the 2nd symbol.

In the above explanation, the intervals S1, S2, S4, and S5 of Fig. 4 illustrate the case where the context number in each interval differs from the context number in the respectively previous interval.

When the context number is different from the context number of the previous interval, the arithmetic decoding unit 111 reads out and chooses the renewed set of the symbol value and probability state, which is already stored in the probability state storing unit 115, and executes arithmetic decoding. The flow of the processing corresponds to an arrow 151 that indicates the flow to the processing "Dec2" from the processing "Cntxt2" of Fig. 4.

On the other hand, an interval S3 of Fig. 4 illustrates the case where a context number is same as the context number in the previous interval S2. In processing "Dec3", the arithmetic decoding unit 111 disregards the renewed set of the symbol value and probability state read out from the probability state storing unit 115, but uses the renewed set of the symbol value and probability state, which the symbol appearing probability control unit 114 has chosen immediately before, and executes arithmetic decoding. The flow of the processing corresponds to an arrow 152 that indicates the flow to the processing "Dec3" from the processing "CntStat2" of Fig. 4.

In the processing described above, the comparison/judgment unit 122 of the context calculating unit 120 decides whether or not the context number is the same context number as in the previous interval by using the data stored in the register 121, and the selector 113 of the arithmetic decoding unit 111 makes selection for the renewed set of the symbol value and probability state, based on the judgment of the comparison/judgment unit 122.

Thus, in the arithmetic decoding device 100 of the present embodiment, the renewed set of the symbol value and probability state is surely transferred to the next arithmetic decoding, in both cases where the context number of the present interval is same or not same as the context number of the previous interval.

Since decoding (for example, processing "Cntxt2") of one input code (VLC) is immediately started after the previous context calculation and read-out processing of the probability state (for example, processing "Cntxt1"), required time for decoding one symbol of the input code (VLC) S 13 is given by a time of each interval, for example, the longest process time of the four kinds of the processing in the interval S2. This is also another important feature of the present embodiment.

As explained above, in the arithmetic decoding device 100 of the present embodiment, required time for decoding one symbol is given by the longer process time between the processing "Cntxt" and the processing "CntStat" (the other two kinds of processing have shorter process time). As the result, improvement in speed of decoding can be attained.

According to the arithmetic decoding device 100 of the present embodiment, while the arithmetic decoding unit 111 decodes one input code (the current input code), the context calculating unit 120 can obtain a context for the next input code, therefore, the arithmetic decoding unit 111 can decode the next input code immediately after finishing decoding of the current input code. Consequently, improvement in speed of decoding is realizable.

According to the arithmetic decoding device 100, while one code is decoded, the symbol appearing probability control unit 114 obtains each renewed set of a symbol value and probability state for the cases where the decoded symbol by the arithmetic decoding unit 111 is a most probable symbol and is a least probable symbol, and after the decoded symbol is fixed, one of the renewed sets is chosen. Consequently, in decoding of the next code, since the arithmetic decoding unit 111 can immediately acquire a necessary set of the symbol value and probability state, and perform decoding processing and writing processing to the probability state recording unit 115. Thereby, improvement in speed of the arithmetic decoding can be further attained.

### (Second embodiment)

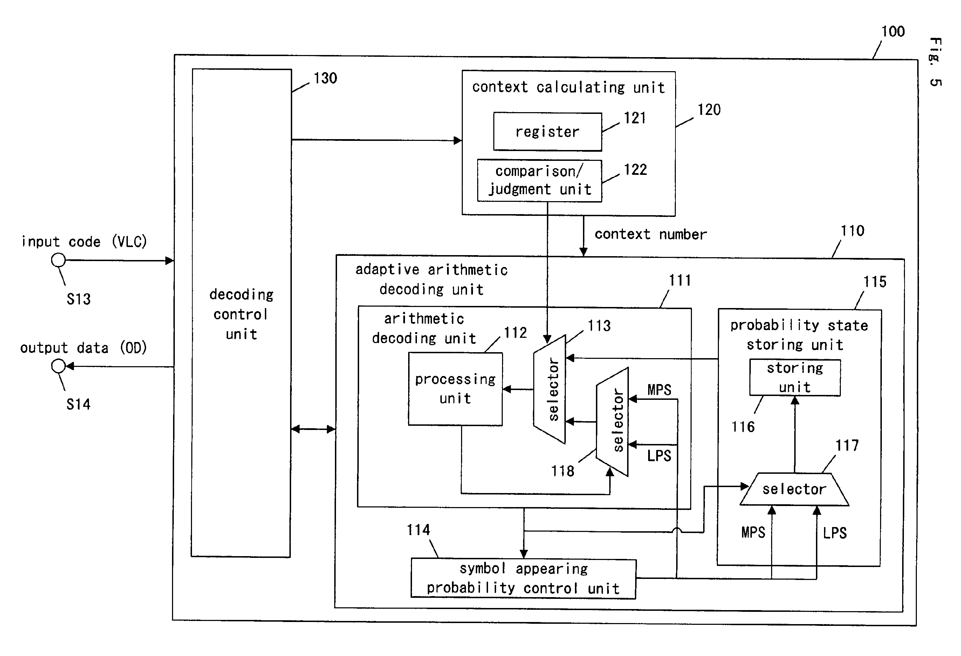

Fig. 5 is a block diagram of an arithmetic decoding device in a second embodiment of the present invention. In Fig. 5, descriptions are omitted by giving the same symbols regarding the same components as in Fig. 3.

The arithmetic decoding device 100 of the present embodiment comprises the adaptive arithmetic decoding unit 110, the context calculating unit 120, and the decoding control unit 130. The adaptive arithmetic decoding unit 110 includes the arithmetic decoding unit 111, the symbol appearing probability control unit 114, and the probability state storing unit 115. The context calculating unit 120 includes the register 121 and the comparison/judgment unit 122.

In the adaptive arithmetic decoding unit 110 of the present embodiment, the arithmetic decoding unit 111 includes the selector 113, a selector 118, and the processing unit 112. The probability state storing unit 115 includes a storing unit 116 and a selector 117.

In the first embodiment of the present invention, the symbol appearing probability control unit 114 receives the symbol information that is decoded by the arithmetic decoding unit 111, determines the renewed set of the symbol value and probability state that is to be used for the next decoding, and sends the result to the probability state storing unit 115 and the selector 113 of the arithmetic decoding unit 111. However, the symbol appearing probability control unit 114 of the present embodiment does not determine the renewed set of the symbol value and probability state that is to be used for the next decoding, the probability state storing unit 115 and the arithmetic decoding unit 111 determine the set instead. In order to complete the determination, the selector 117 and the selector 118 are newly incorporated in the probability state storing unit 115 and the arithmetic decoding unit 111, respectively.

In other words, the symbol appearing probability control unit 114 outputs "MPS" that is a renewed set of a symbol value and probability state in case where the decoded symbol is a most probable symbol, and "LPS" that is a renewed set of a symbol value and probability state in case where the decoded symbol is a least probable symbol, and sends them to the selector 117 and the selector 118.

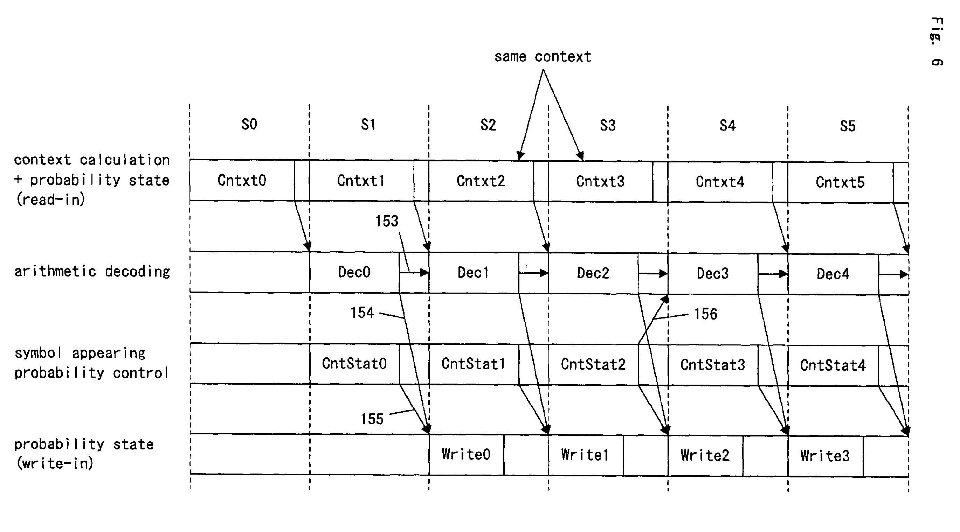

In the following, referring to Fig. 5 and Fig. 6, operation of the adaptive arithmetic ) decoding unit 110 of the present embodiment is explained for points different from the first embodiment of the present invention.

Fig. 6 is a timing chart of the arithmetic decoding device in the second embodiment of the present invention. In the figure, intervals except for the interval S2 and the interval S3 illustrates the case where the context number of each interval is different from a context number of the previous interval. The interval S2 and the interval S3 illustrate the case where the context numbers are the same (that is, contexts are the same).

The interval S1, which has a different context number from the previous interval, is explained. In the interval S1, the arithmetic decoding unit 111 performs the processing "Dec0", arithmetic-decoding the 0th input code (VLC) S13, and outputting the code as the output data (OD) S 14. Simultaneously, the arithmetic decoding unit 111 sends decoded symbol information to the selector 118 within the arithmetic decoding unit 111 (an arrow 153 of Fig. 6) and to the selector 117 of the probability state storing unit 115 (an arrow 154 of Fig. 6).

In the interval S1, the symbol appearing probability control unit 114 performs processing "CntStat0", determines the "MPS" that is the renewed set of the symbol value and probability state in case where the decoded symbol is a most probable symbol, and the "LPS" that is the renewed set of the symbol value and probability state in case where the decoded symbol is a least probable symbol, and outputs the renewed sets to the selector 118 and the selector 117 immediately (an arrow 155 of Fig. 6). As mentioned later, since output to the selector 118 is not used in the processing "Dec 1", it is not illustrated.

Consequently, in the processing "CntStat0", since the symbol appearing probability control unit 114 does not perform the determination processing of a renewed value, the arithmetic decoding unit 111 does not need to wait till the decoded symbol information is determined; therefore, reduction in process time can be achieved.

Similarly, in the interval S2 where the context number is different from the context number in the previous interval, in the processing "Dec1", the selector 113 chooses the renewed set of the symbol value and probability state that has already been stored in the probability state storing unit 115 based on the result of the comparison/judgment unit 122, and the processing unit 112 performs decoding using the renewed set chosen by the selector 113.

In the processing "Write0", the selector 117 chooses either one of the "MPS" that is the renewed set of the symbol value and probability state in case where the decoded symbol is a most probable symbol, and the "LPS" that is the renewed set of the symbol value and probability state in case where the decoded symbol is a least probable symbol, based on the decoded symbol information in the arithmetic decoding unit 111. After the selection is made, the selector 117 stores the result in the storing unit 116.

In the interval S3, the processing "Dec2", the processing "CntStat2", and the processing "Write1" are the same as the respectively corresponding processing in the interval S2. However, in the processing "cntxt3", since the context number generated to the 3rd symbol is the same as the context number generated to the 2nd symbol, the following processing is performed in the arithmetic decoding unit 111.

In the processing "Dec3" of the interval S4, the selector 118 chooses either one of the "MPS" that is the renewed set of the symbol value and probability state in case where the decoded symbol is a most probable symbol, and the "LPS" that is the renewed set of the symbol value and probability state in case where the decoded symbol is a least probable symbol, based on the decoded symbol information of the processing result of the processing unit 112. After the selection is made, the selector 118 sends the result to the selector 113. The selector 113 receives the judgment result of the comparison/judgment unit 122 of the context calculating unit 120 (an arrow 156 of Fig. 6), and chooses the selection result of the selector 118. The processing unit 112 performs decoding using the selection result chosen by the selector 118.

According to the arithmetic decoding device 100 of the present embodiment, the symbol appearing probability control unit 114 does not determine the renewed set of the symbol value and probability state that is to be used for the next decoding, but leaves the determination to the probability state storing unit 115 and the arithmetic decoding unit 111. The determination processing of the renewed value, which is performed based on the decoded symbol information of the processing result of the processing unit 112, is executed at the beginning of the next interval in the arithmetic decoding unit 111 and the probability state storing unit 115. Therefore, the process time of each element can be equalized and the further improvement in speed is attained comparing to the first embodiment of the present invention.

According to the arithmetic decoding device 100 of the present embodiment, thanks to the structure that gives to the arithmetic decoding unit 111 the two kinds of sets of the symbol value and probability state, which are determined in advance by the symbol appearing probability control unit 114; when the same context is decoded, either one of two kinds of renewed sets of the symbol value and probability state can be chosen as soon as the decoded result is acquired, and decoding of the next code can be started. Thereby, further improvement in speed of the arithmetic decoding can be attained.

### (Third embodiment)

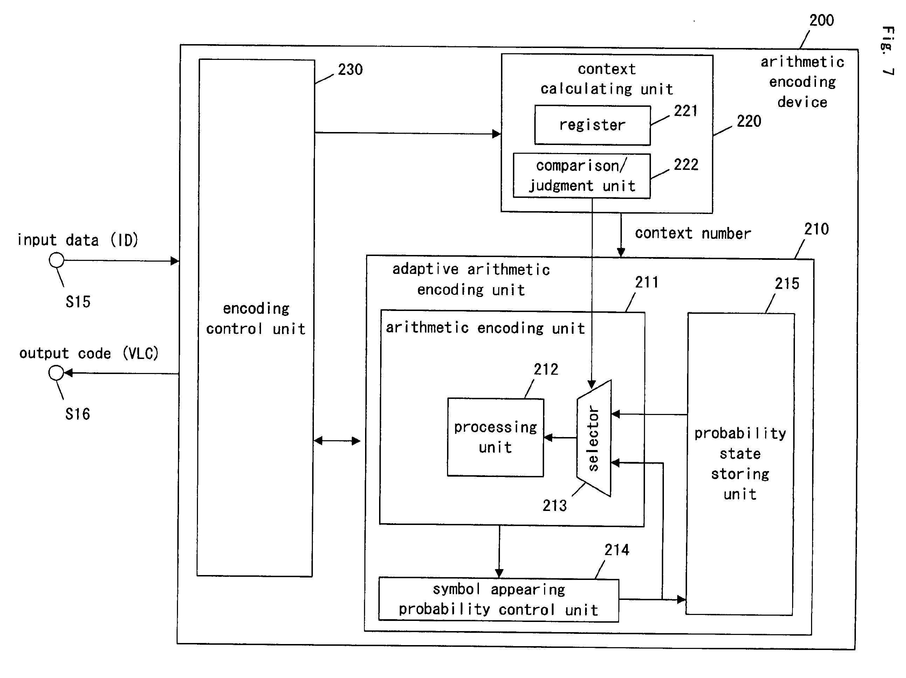

Fig. 7 is a block diagram of an arithmetic encoding device 200 according to a third embodiment of the present invention.

As shown in Fig. 7, the arithmetic encoding device 200 of the present embodiment comprises an adaptive arithmetic encoding unit 210, a context calculating unit 220, and an encoding control unit 230. The context calculating unit 220 includes a register 221 and a comparison/judgment unit 222. The adaptive arithmetic encoding unit 210 includes an arithmetic encoding unit 211, a symbol appearing probability control unit 214, and a probability state storing unit 215.

In the following, operation of the arithmetic encoding device 200 of the present embodiment is outlined.

A context calculating unit 220 generates a context number by the classification and the decoded bit number of a syntax element. The encoding control unit 230 performs overall controls for the arithmetic encoding device 200.

The following processing is performed in the adaptive arithmetic encoding unit 210. The probability state storing unit 215 stores, for each context number, a probability state which designates a most probable symbol (or a least probable symbol) and an appearing probability of the symbol. Based on a set of a symbol value and probability state which has been received from the probability state storing unit 215, the arithmetic encoding unit 211 performs arithmetic encoding of input data (ID) S 15, and outputs an output code (VLC) S16. Upon receiving encoded symbol information from the arithmetic encoding unit 211, the symbol appearing probability control unit 214 determines a renewed set of the symbol value and probability state to be used for the next encoding, and stores the renewed set into the probability state storing unit 215.

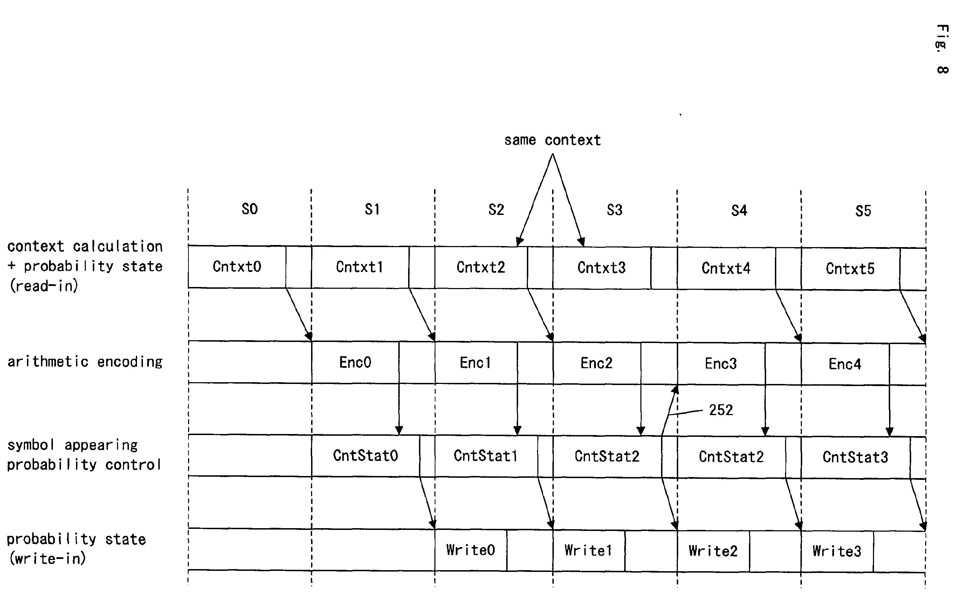

Next, a flow of processing of the arithmetic encoding device 200 of the present embodiment is described with reference to Fig. 7 and Fig. 8.

Fig. 8 is a timing chart of the arithmetic encoding device 200 according to the third embodiment of the present invention. In Fig. 8, it is assumed that a context processed in the interval S2 and a context processed in the interval S3 are same, and a context of the other intervals is different from a context of the respectively previous interval.

In Fig. 8, the interval S2 of which the context differs from the context of the previous interval is described.

In the interval S2, processing "Cntxt2", processing "Enc1", processing "CntStat1", and processing "Write0" are executed.

In the processing "Cntxt2", for the second symbol of the input data (ID) S15, the context calculating unit 220 generates a context number, and sends the context number to the adaptive arithmetic encoding unit 210. The arithmetic encoding unit 211 reads, from the probability state storing unit 215, a set of the symbol value and probability state in accordance with the context number sent from the context calculating unit 220.

In the processing "Enc1", the arithmetic encoding unit 211 performs arithmetic encoding of the first input data (ID) S 15 according to the previous set of the symbol value and probability state, and outputs the encoded result as an output code (VLC) S16. Simultaneously, the arithmetic encoding unit 211 gives encoded symbol information to the symbol appearing probability control unit 214.

In the processing "CntStat1", after the interval S2 begins and before the encoded symbol is determined, the symbol appearing probability control unit 214 determines each renewed set of a symbol value and probability state to the first symbol, for a case where the encoded symbol is a most probable symbol and a case where the encoded symbol is a least probable symbol. The symbol appearing probability control unit 214 selects and outputs one of the renewed values after the encoded symbol is determined.

In the processing "Write0", the symbol appearing probability control unit 214 writes in the probability state storing unit 215 the renewed set of the symbol value and probability state of the encoded symbol to the 0th symbol, the renewed set being selected in the interval S 1.

As for the rest of the intervals, processing of an interval where a context differs from a context of the previous interval is the same as the processing of the interval S2.

In an interval where a context is the same as a context of the previous interval, the arithmetic encoding unit 211 ignores the renewed set of the symbol value and probability state read from the probability state storing unit 215, and adopts the renewed set of the symbol value and probability state which the symbol appearing probability control unit 214 has selected immediately before, and executes arithmetic encoding processing (it corresponds to an arrow 252 which indicates a flow to processing "Enc3" from the processing "CntStat2" of Fig. 8).

In the processing described above, the comparison/judgment unit 222 of the context calculating unit 220 judges if a context number of the current interval is the same as a context number of the previous interval, using data stored in the register 221. A selector 213 of the arithmetic encoding unit 211 executes selection of the renewed sets of the symbol value and probability state, based on the judgment result of the comparison/judgment unit 222.

Thus, in the arithmetic encoding device 200 of the present embodiment, a renewed set of a symbol value and probability state is certainly transferred to the next arithmetic encoding both when a context number of the current interval is the same as a context number of the previous interval and when the context number of the current interval differs from the context number of the previous interval.

The other important feature of the present embodiment is that time consumed for the encoding of one symbol is given by each interval, for example, the longest process time among the several kinds of processing in the interval S2. This is because encoding of input data (ID) S15 (for example, the processing "Cntxt2" of Fig. 8) is started immediately after the processing of the previous context calculation and the processing of reading-out probability state (for example, the processing "Cntxt1 "of Fig. 8).

As described above, in the arithmetic encoding device 200 of the present embodiment, the time consumed for the encoding of one symbol is set with processing with the longer process time between the processing "Cntxt" and the processing "CntStat" (other two kinds of the processing have shorter process time). Thereby, improvement in speed of the encoding processing can be realized.

According to the arithmetic encoding device 200 of the present embodiment, while a certain input signal (the current input signal) is encoded in the arithmetic encoding unit 211, the context calculating unit 220 can determine a context for the following input signal, the arithmetic encoding unit 211 can perform encoding of the following input signal immediately after finishing encoding of the current input signal. Therefore, improvement in speed of the encoding processing can be realized.

According to the arithmetic encoding device 200 of the present embodiment, while a certain signal is encoded in the arithmetic encoding unit 211, the symbol appearing probability control unit 214 determines each renewed set of the symbol value and probability state for a case where an encoded symbol encoded by the arithmetic encoding unit 211 is a most probable symbol and a case where the encoded symbol encoded by the arithmetic encoding unit 211 is a least probable symbol, and selects one of the renewed sets after the encoded symbol is determined. Thereby, the arithmetic encoding unit 211 can acquire a set of the symbol value and probability state, the set being necessary in encoding of the following code, and can immediately perform processing of encoding and processing of writing to the probability state recording unit 215. This means that the further improvement in speed of arithmetic encoding processing can be realized.

### (Fourth embodiment)

Fig. 9 is a block diagram of an arithmetic encoding device 200 according to a fourth embodiment of the present invention. In Fig. 9, description is omitted by attaching the same symbols regarding the same components as in Fig. 7.

The arithmetic encoding device 200 of the present embodiment comprises the adaptive arithmetic encoding unit 210, the context calculating unit 220, and the encoding control unit 230. The adaptive arithmetic encoding unit 210 includes the arithmetic encoding unit 211, the symbol appearing probability control unit 214, and the probability state storing unit 215, and the context calculating unit 220 includes the register 221 and the comparison/judgment unit 222.

In the adaptive arithmetic encoding unit 210 of the present embodiment, the arithmetic encoding unit 211 includes the selector 213, a selector 218, and a processing unit 212, and the probability state storing unit 215 includes a storing unit 216 and a selector 217.

In the third embodiment of the present invention, upon receiving the encoded symbol information in the arithmetic encoding unit 211, the symbol appearing probability control unit 214 determines a renewed set of a symbol value and probability state, the set being to be used for the next encoding, and sends the renewed set to the probability state storing unit 215 and the selector 213 of the arithmetic encoding unit 211. However, the symbol appearing probability control unit 214 of the present embodiment does not perform the determination of the renewed set of the symbol value and probability state which are used for the next encoding, but the determination is performed in the probability state storing 215 and the arithmetic encoding unit 211. For the determination processing, the selector 217 and the selector 218 are newly incorporated in the probability state storing unit 215 and the arithmetic decoding unit 211, respectively.

In other words, the symbol appearing probability control unit 214 outputs "MPS" that is a renewed set of a symbol value and probability state in case where the encoded symbol is a most probable symbol, and "LPS" that is a renewed set of a symbol value and probability state in case where the encoded symbol is a least probable symbol, and sends them to the selector 217 and the selector 218.

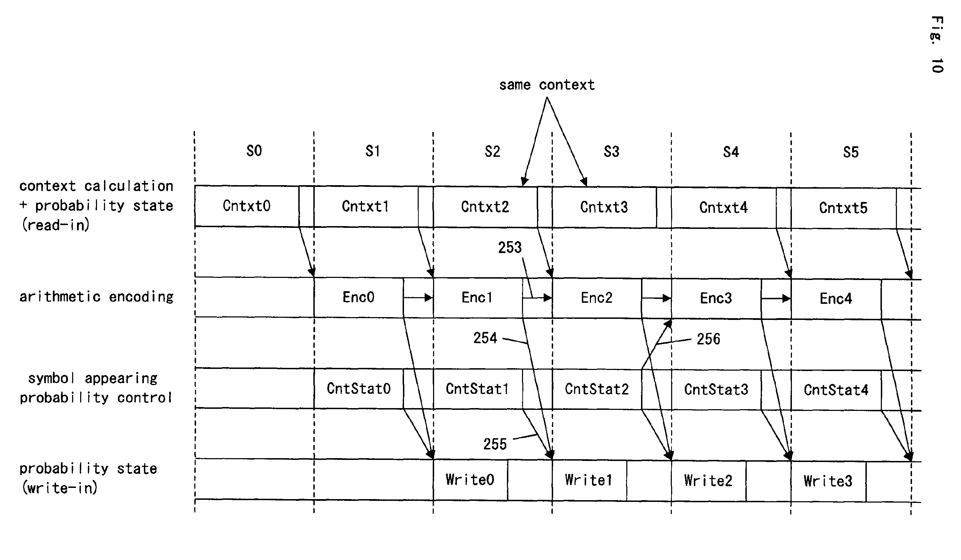

Hereinafter, with reference to Fig. 9 and Fig. 10, operation of the adaptive arithmetic encoding unit 210 of the present embodiment is described regarding points different from the third embodiment of the present invention.

Fig. 10 is a timing chart of the arithmetic encoding device 200 according to the fourth embodiment of the present invention.

In Fig. 10, intervals other than the interval S3 illustrates a case where the context number of each interval differs from a context number of the respectively previous interval. The interval S3 illustrates a case where the context number is the same as in the previous interval S2 (that is, the contexts are the same).

Operation of the arithmetic encoding device 200 of the present embodiment is described hereinafter for the interval S2, of which the context number is different from the context number of the previous interval.

In the interval S2, the arithmetic encoding unit 211 performs processing "Enc1", arithmetic-encoding the first input data (ID) S 15, and outputting the result as the output code (VLC) S16. Simultaneously, the arithmetic encoding unit 211 sends encoded symbol information to the selector 218 within the arithmetic encoding unit 211 (an arrow 253 of Fig. 10) and to the selector 217 of the probability state storing unit 215 (an arrow 254 of Fig. 10).

In the interval S2, the symbol appearing probability control unit 214 performs processing "CntStat1", determines the "MPS" that is the renewed set of the symbol value and probability state when the encoded symbol is a most probable symbol, and the "LPS" that is the renewed set of the symbol value and probability state when the encoded symbol is a least probable symbol, and outputs the renewed sets to the selector 218 and the selector 217 immediately (an arrow 255 of Fig. 10). As described later, since output to the selector 218 is not used in the processing "Enc2", an illustration is omitted for the case.

Consequently, in the processing "CntStat1", since the symbol appearing probability control unit 214 does not perform the determination processing of a renewed value, it is not necessary to wait for the encoded symbol information to be determined in the arithmetic encoding unit 211; thereby shortening of process time is achieved.

In the processing "Write0", based on the encoded symbol information fed by the arithmetic encoding unit 211, the selector 217 selects either one of the "MPS" that is the renewed set of the symbol value and probability state when the encoded symbol is a most probable symbol or the "LPS" that is the renewed set of the symbol value and probability state when the encoded symbol is a least probable symbol, and stores the selected result in the storing unit 216.

In the interval S2, the context calculation "Cntxt2" for the following context is executed in parallel with the processing "Enc1", the processing "CntStat1 ", and the processing "Write0."

The processing "Enc2", the processing "CntStat2", and the processing "Write1" in the interval S3 are the same as the respectively corresponding processing in the interval S2. However, in the processing "cntxt3", since the context number generated to the third symbol is the same as the context number generated to the second symbol, the following processing is performed in the arithmetic encoding unit 211.

In the processing "Enc3" of the interval S4, based on the encoded symbol information on the processing result of the processing unit 212, the selector 218 selects either the "MPS", the renewed set of the symbol value and probability state when the encoded symbol is a most probable symbol, or the "LPS", the renewed set of the symbol value and probability state when the encoded symbol is a least probable symbol, and sends the result to the selector 213. The selector 213 selects the selection result of the selector 218 in accordance with the judgment result of the comparison/judgment unit 222 (an arrow 256 of Fig. 10). The processing unit 212 performs encoding using the selection result chosen by the selector 213.

Thus, according to the arithmetic encoding device 200 of the present embodiment, the symbol appearing probability control unit 214 does not perform determining the renewed set of the symbol value and probability state which is used for the next encoding, but leaves the determination to the probability state storing unit 215 and the arithmetic encoding unit 211. The determination processing of the renewed value, which is performed based on the encoded symbol information on the processing result of the processing unit 212, is executed at the beginning of the next interval in the arithmetic encoding unit 211 and the probability state storing unit 215. Consequently, the process time of each element can be equalized and the further improvement in the speed of encoding can be obtained compared with the third embodiment of the present invention.

According to the arithmetic encoding device 200 of the present embodiment, due to the construction which gives to the arithmetic encoding unit 211 two kinds of renewed sets of the symbol value and probability state, which are preceded and determined in the symbol appearing probability control unit 214; when performing the next encoding with the same context, one of two kinds of the renewed sets of the symbol value and probability state is selected as soon as the encoded result is obtained, and encoding of the next code can be started. Thereby, further improvement in the speed of the arithmetic encoding processing can be obtained.

### (Fifth embodiment)

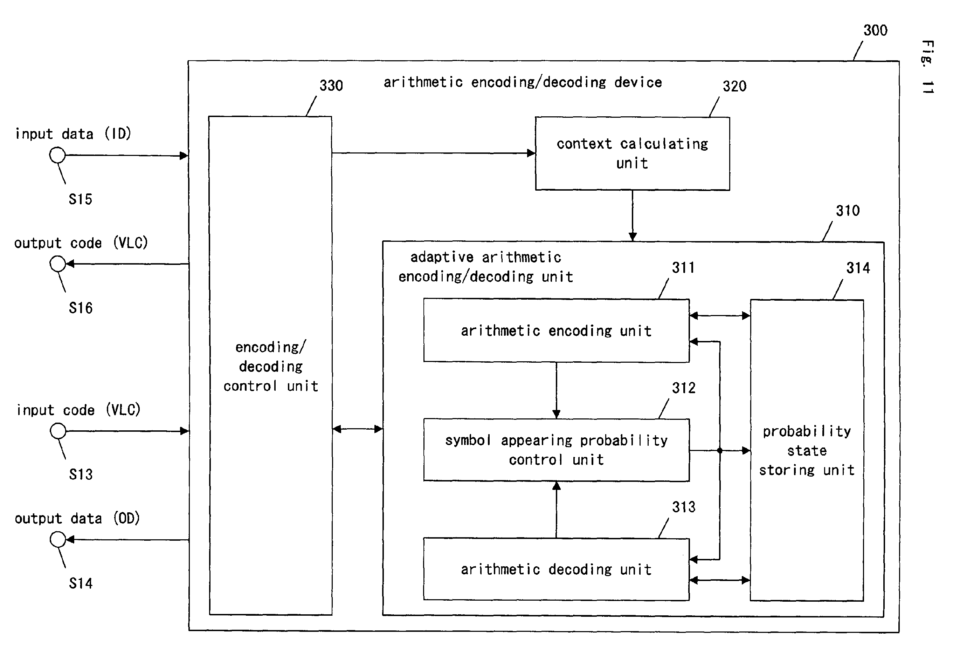

Fig. 11 is a block diagram of an arithmetic encoding/decoding device 300 according to a fifth embodiment of the present invention. In Fig. 11, description is omitted by attaching the same symbols regarding the same components as in Fig. 3 and Fig. 7.

As shown in Fig. 11, the arithmetic encoding/decoding device 300 of the present embodiment comprises an adaptive arithmetic encoding/decoding unit 310, a context calculating unit 320, and an encoding/decoding control unit 330.

The adaptive arithmetic encoding/decoding unit 310 includes an arithmetic encoding unit 311, an arithmetic decoding unit 313, a symbol appearing probability control unit 312, and a probability state storing unit 314.

In the adaptive arithmetic encoding/decoding unit 310, the probability state storing unit 314 stores, for each context number, a probability state which indicates a most probable symbol (or a least probable symbol) and an appearing probability of the symbol. Based on the set of a symbol value and probability state which has been received from the probability state storing unit 314, the arithmetic encoding unit 311 performs arithmetic encoding of the input data (ID) S15, and outputs the output code (VLC) S16. Based on the set of the symbol value and probability state which has been received from the probability state storing unit 314, the arithmetic decoding unit 313 performs arithmetic decoding of the input code (VLC) S 13, and outputs the output data (OD) S 14.

The symbol appearing probability control unit 312 determines a renewed set of the symbol value and probability state to be used for the next encoding, in accordance with the encoded symbol information fed by the arithmetic encoding unit 311 in encoding. The symbol appearing probability control unit 312 also determines a renewed set of the symbol value and probability state to be used for the next decoding in accordance with decoded symbol information fed by the arithmetic decoding unit 313 in decoding.

According to the arithmetic encoding/decoding device 300 of the present embodiment, the encoding operation of the arithmetic encoding device 200 described in full detail in the third or the fourth embodiment of the present invention is performed in encoding, and the decoding operation of the arithmetic decoding device 100 described in full detail in the first or the second embodiment of the present invention is performed in decoding.

In the arithmetic encoding/decoding device 300 of the present embodiment, encoding and decoding can be performed with one device with high efficiency.

With the configuration of the present embodiment, the symbol appearing probability control unit 312, the context calculating unit 320, and the encoding/decoding control unit 330 are shared in encoding and decoding; thereby reduction of a circuit scale and reduction of power consumption are attainable.

### (Sixth embodiment)

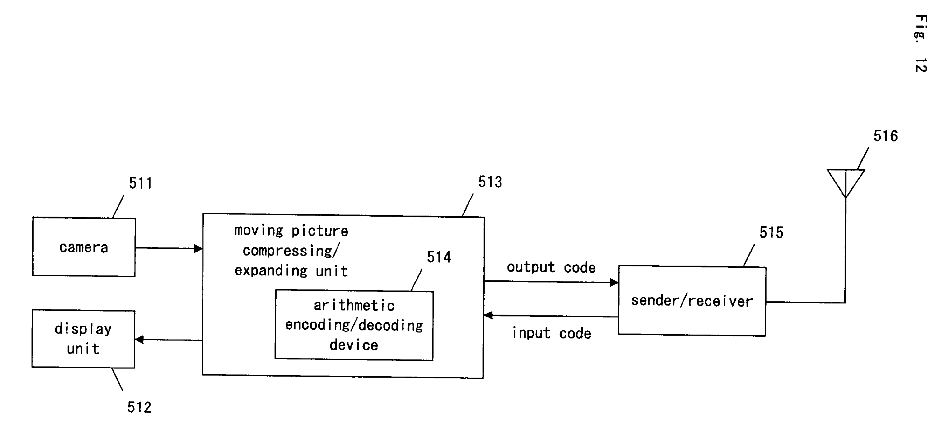

Fig. 12 is a block diagram of a portable terminal device according to a sixth embodiment of the present invention.

The portable terminal device of the present embodiment comprises a camera 511, a display unit 512, a moving picture compressing/expanding unit 513, a sender/receiver 515, and an antenna 516. The moving picture compressing/expanding unit 513 includes an arithmetic encoding/decoding device 514. The arithmetic encoding/decoding device 514 is equivalent to the arithmetic encoding/decoding device 300 according to the fifth embodiment of the present invention.

In sending mode of the portable terminal device of the present embodiment, the camera 511 shoots a moving picture and the moving picture compressing/expanding unit 513 performs arithmetic encoding for the moving picture as input data (ID), thus yielding an output code. The sender/receiver 515 sends the output code from the antenna 516. In receiving mode of the portable terminal device, the sender/receiver 515 feeds an input code received by the antenna 516 to the moving picture compressing/expanding unit 513. The moving picture compressing/expanding unit 513 performs arithmetic decoding for the input code, and outputs the decoded result to the display unit 512. The display unit 512 displays the decoded result as a received image.

The portable terminal device of the present embodiment comprises the arithmetic encoding/decoding device 300 according to the fifth embodiment of the present invention in the core of the moving picture compressing/expanding unit 513, and can process arithmetic encoding and decoding at high speed. Therefore, sending and receiving of a higher-quality moving picture can be realized.

The moving picture compressing/expanding unit 513 of the portable terminal device of the present embodiment can also be composed by comprising the arithmetic decoding device 100 according to the first embodiment or the second embodiment of the present invention, and the arithmetic encoding device 200 according to the third embodiment or the fourth embodiment of the present invention. In this case, the portable terminal device can claim features which the arithmetic decoding device 100 and the arithmetic encoding device 200 possess.

### (Seventh embodiment)

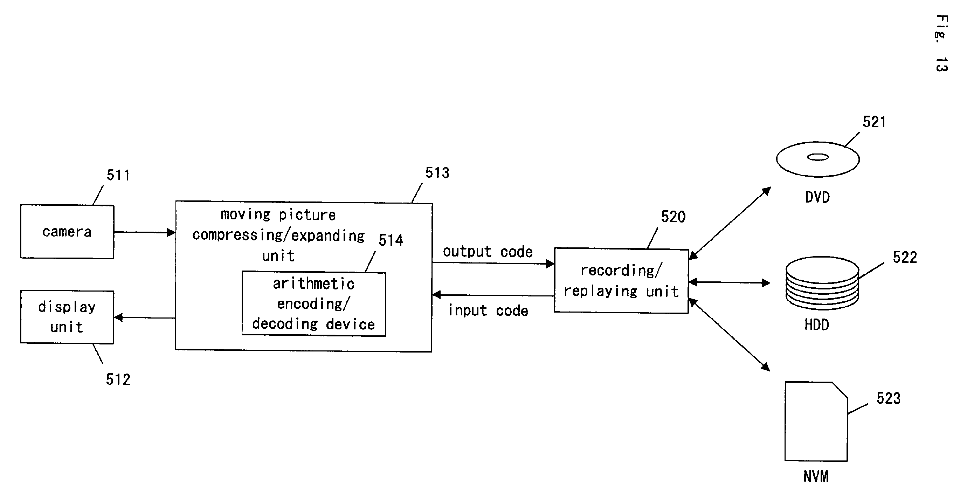

Fig. 13 is a block diagram of a moving picture shooting device according to a seventh embodiment of the present invention. In Fig. 13, description is omitted by attaching the same symbols regarding the same components as in Fig. 12.

The moving picture shooting device of the present embodiment comprises the camera 511, the display unit 512, the moving picture compressing/expanding unit 513, a recording/replaying unit 520, and a DVD (digital video disc)521, an HDD (hard disk drive)522 and an NVM (non-volatile memory)523. The moving picture compressing/expanding unit 513 includes the arithmetic encoding/decoding device 514 which is equivalent to the arithmetic encoding/decoding device 300 according to the fifth embodiment of the present invention.

The recording/replaying unit 520 records on recording media, such as the DVD521, the HDD522, and the NVM523, an output code obtained after the moving picture compressing/expanding unit 513 arithmetic-encodes a moving picture shot with the camera 511. The recording/replaying unit 520 also replays the moving picture that is recorded on the DVD521, the HDD522, and the NVM523, and outputs the moving picture to the moving picture compressing/expanding unit 513 as an input code. The moving picture compressing/expanding unit 513 performs arithmetic decoding of the input code, to generate a decoded result. The display unit 512 displays the decoded result as a display image.

The moving picture shooting device of the present embodiment comprises the arithmetic encoding/decoding device 300 according to the fifth embodiment of the present invention in the core of the moving picture compressing/expanding unit 513. Therefore, shooting, recording/replaying, and displaying a higher-quality moving picture can be obtained.

The moving picture compressing/expanding unit 513 of the moving picture shooting device of the present embodiment can be alternatively composed by the arithmetic decoding device 100 according to the first embodiment or the second embodiment of the present invention, and the arithmetic encoding device 200 according to the third embodiment or the fourth embodiment of the present invention. In this case, the moving picture shooting device of the present embodiment can claim features which the arithmetic decoding device 100 and the arithmetic encoding device 200 possess.

It is suffice for the recording medium of the present embodiment to comprise at least one of the DVD521, the HDD522, and the NVM523. The recording medium of the present embodiment can also comprise a magnetic tape.

### (Eighth embodiment)

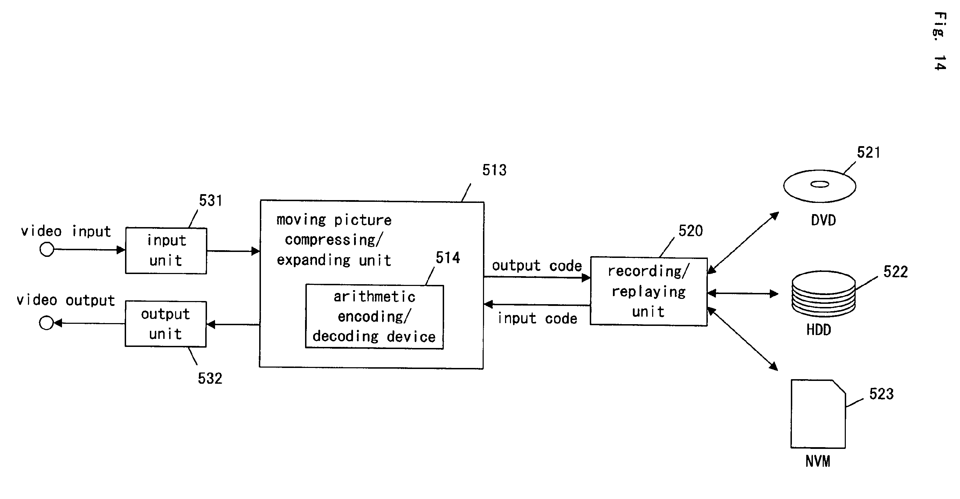

Fig. 14 is a block diagram of a moving picture recording/replaying device according to an eighth embodiment of the present invention. In Fig. 14, description is omitted by attaching the same symbols regarding the same components as in Fig. 12 and Fig. 13.

The moving picture recording/replaying device of the present embodiment comprises an input unit 531, an output unit 532, the moving picture compressing/expanding unit 513, the recording/replaying unit 520, and the DVD (digital video disc)521, the HDD (hard disk)522, and the NVM (non-volatile memory)523. The moving picture compressing/expanding unit 513 includes the arithmetic encoding/decoding device 514 which is equivalent to the arithmetic encoding/decoding device 300 according to the fifth embodiment of the present invention.

The input unit 531 is an input interface which receives a video-input from the outside. The input unit 531 may preferably have a function of format conversion or pre-filtering of the video-input.

The output unit 532 is an output interface which feeds a video-output to the outside. The output unit 532 may preferably have a function of format conversion or post-filtering for an expanded image decoded by the moving picture compressing/expanding unit 513.

The moving picture recording/replaying device of the present embodiment comprises the arithmetic encoding/decoding device 300 according to the fifth embodiment of the present invention in the core of the moving picture compressing/expanding unit 513. Therefore, the moving picture recording/replaying device can perform the arithmetic encoding and decoding at high speed; thereby, recording and replaying of a higher-quality moving picture can be realized.

The moving picture compressing/expanding unit 513 of the moving picture recording/replaying device of the present embodiment can be alternatively composed by the arithmetic decoding device 100 according to the first embodiment or the second embodiment of the present invention, and the arithmetic encoding device 200 according to the third embodiment or the fourth embodiment of the present invention. In this case, the moving picture recording/replaying device can claim features which the arithmetic decoding device 100 and the arithmetic encoding device 200 possess.

It is suffice for the recording medium of the present embodiment to comprise at least one of the DVD521, the HDD522, and the NVM523. The recording medium of the present embodiment can also comprise a magnetic tape.

As described above, what is aimed at by the present invention is that context calculation and encoding of an input signal is processed in parallel in encoding, and context calculation and decoding of an input code is processed in parallel in decoding, thereby, realizing improvement in speed of encoding/decoding. Therefore, various applications are possible unless the aim of the present invention is deviated.

According to the present invention, an arithmetic encoding/decoding device with a high-speed processing capability can be provided as practical implementing of an arithmetic encoding/decoding process that is recommended by the ITU-T standard H.264. Furthermore, a portable terminal device and a moving picture shooting device, and a moving picture recording/replaying device using the arithmetic encoding/decoding device can be provided.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims.

## Claims

1. An arithmetic decoding device (40) comprising:
an arithmetic decoding unit (11) operable to decode an encoded moving picture inputted, thereby outputting a decoded symbol as a result of decoding;
a context calculating unit (20) operable to calculate a context number for the encoded moving picture, thereby feeding the calculated context number to said arithmetic decoding unit (11);
a symbol appearing probability control unit (12) operable to renew a set of a symbol value and a symbol appearing probability for one of a most probable symbol and a least probable symbol, based on the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic decoding unit (11) decodes an n-th code of the encoded moving picture, said context calculating unit (20) is operable in parallel to calculate the context number of an (n+1)-th code of the encoded moving picture, the (n+1)-th code being next to the n-th code, where n is a natural number.

2. An arithmetic decoding device (40) comprising:
an arithmetic decoding unit (11) operable to decode an encoded moving picture inputted, thereby outputting a decoded symbol as a result of decoding;
a context calculating unit (20) operable to calculate a context number for the encoded moving picture, thereby feeding the calculated context number to said arithmetic decoding unit (11);
a symbol appearing probability control unit (12) operable to renew a set of a symbol value and a symbol appearing probability for one of a most probable symbol and a least probable symbol, based on the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic decoding unit (11) decodes a code of the encoded moving picture, said symbol appearing probability control unit (12) is operable in parallel to calculate two kinds of renewed values for the set of the symbol value and the symbol appearing probability for the code, one of the two kinds of the renewed values being for a case when said arithmetic decoding unit (11) decodes a most probable symbol and the other of the two kinds of the renewed values being for a case when said arithmetic decoding unit (11) decodes a least probable symbol, and said symbol appearing probability control unit (12) is operable to select more suited one of the two kinds of the renewed values after said arithmetic decoding unit determines the decoded symbol.

3. The arithmetic decoding device (40) as defined in claim 2, wherein said symbol appearing probability control unit (12) is operable to feed said arithmetic decoding unit (11) the two kinds of the renewed values for the set of the symbol value and the symbol appearing probability, and
wherein when said arithmetic decoding unit (11) decodes an encoded moving picture with a same context number, said arithmetic decoding unit (11) is operable, based on a symbol decoded immediately previously, to select more suited one of the two kinds of the renewed values.

4. The arithmetic decoding device (40) as defined in claim 1, wherein said probability state storing unit (12) is operable to store the symbol appearing probability in terms of a probability state number.

5. An arithmetic encoding device (40) comprising:
an arithmetic encoding unit (11) operable to arithmetic-encode a moving picture signal inputted, thereby outputting an encoded symbol as a result of arithmetic encoding;
a context calculating unit (20) operable to calculate a context number for the moving picture signal, thereby feeding the calculated context number to said arithmetic encoding unit (11);
a symbol appearing probability control unit (12) operable to renew a set of a symbol value and a symbol appearing probability for one of a most probable symbol and a least probable symbol, based on the encoded symbol outputted by said arithmetic encoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes an n-th moving picture signal, said context calculating unit (20) is operable in parallel to calculate the context number of an (n+1)-th moving picture signal, the (n+1)-th moving picture signal being next to the n-th moving picture signal, where n is a natural number.

6. An arithmetic encoding device (40) comprising:
an arithmetic encoding unit (11) operable to arithmetic-encode a moving picture signal inputted, thereby outputting an encoded symbol as a result of arithmetic encoding;
a context calculating unit (20) operable to calculate a context number for the moving picture signal, thereby feeding the calculated context number to said arithmetic encoding unit (11);
a symbol appearing probability control unit (12) operable to renew a set of a symbol value and a symbol appearing probability for one of a most probable symbol and a least probable symbol, based on the encoded symbol outputted by said arithmetic encoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes a moving picture signal, said symbol appearing probability control unit (12) is operable in parallel to calculate two kinds of renewed values for the set of the symbol value and the symbol appearing probability for the moving picture signal, one of the two kinds of the renewed values being for a case when said arithmetic encoding unit (11) arithmetic-encodes a most probable symbol and the other of the two kinds of the renewed values being for a case when said arithmetic encoding unit (11) arithmetic-encodes a least probable symbol, and said symbol appearing probability control unit (12) is operable to select more suited one of the two kinds of the renewed values after said arithmetic encoding unit (11) determines the encoded symbol.

7. The arithmetic encoding device (40) as defined in claim 6, wherein said symbol appearing probability control unit (12) is operable to feed said arithmetic encoding unit (11) the two kinds of the renewed values for the set of the symbol value and the symbol appearing probability, and
wherein when said arithmetic encoding unit (11) arithmetic-encodes a moving picture signal with a same context number, said arithmetic encoding unit (11) is operable, based on a symbol encoded immediately previously, to select more suited one of the two kinds of the renewed values.

8. The arithmetic encoding device (40) as defined in claim 5, wherein said probability state storing unit (13) is operable to store the symbol appearing probability in terms of a probability state number.

9. An arithmetic encoding/decoding device (40) comprising:
an arithmetic encoding unit (11) operable to arithmetic-encodes a moving picture signal inputted, thereby outputting an encoded symbol as a result of arithmetic encoding;
an arithmetic decoding unit (11) operable to decode an encoded moving picture inputted, thereby outputting a decoded symbol as a result of decoding;
a context calculating unit (20) operable to calculate a first context number for the moving picture signal, thereby feeding the first calculated context number to said arithmetic encoding unit (11), and said context calculating unit (20) being further operable to calculate a second context number for the encoded moving picture, thereby feeding the second calculated context number to said arithmetic decoding unit (11);
a symbol appearing probability control unit (12) operable to renew a set of a symbol value and a symbol appearing probability for one of a most probable symbol and a least probable symbol, based on one of the encoded symbol outputted by said arithmetic encoding unit (11) and the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes an m-th moving picture signal, said context calculating unit (20) is operable in parallel to calculate the first context number of an (m+1)-th moving picture signal, the (m+1)-th moving picture being next to the m-th moving picture, where m is a natural number; and
wherein, while said arithmetic decoding unit (11) decodes an n-th code of the encoded moving picture, said context calculating unit (20) is operable in parallel to calculate the second context number of an (n+1)-th code of the encoded moving picture, the (n+1)-th code being next to the n-th code, where n is a natural number.

10. An arithmetic encoding/decoding device (40) comprising:
an arithmetic encoding unit (11) operable to arithmetic-encode a moving picture signal inputted, thereby outputting an encoded symbol as a result of arithmetic encoding;
an arithmetic decoding unit (11) operable to decode an encoded moving picture inputted, thereby outputting a decoded symbol as a result of decoding;
a context calculating unit (20) operable to calculate a first context number for the moving picture signal, thereby feeding the first context number to said arithmetic encoding unit (11), and said context calculating unit (20) being further operable to calculate a second context number for the encoded moving picture, thereby feeding the second context number to said arithmetic decoding unit (11);
a symbol appearing probability control unit (12) operable to renew a set of a symbol value and a symbol appearing probability for one of a most probable symbol and a least probable symbol, based on one of the encoded symbol outputted by said arithmetic encoding unit (11) and the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes a moving picture signal, said symbol appearing probability control unit (12) is operable in parallel to calculate two kinds of renewed values for the set of the symbol value and the symbol appearing probability for the moving picture signal, one of the two kinds of the renewed values being for a case when said arithmetic encoding unit (11) arithmetic-encodes a most probable symbol and the other of the two kinds of the renewed values being for a case when said arithmetic encoding unit (11) arithmetic-encodes a least probable symbol, and said symbol appearing probability control unit (12) is operable to select more suited one of the two kinds of the renewed values after said arithmetic encoding unit (11) determines the encoded symbol, and
wherein, while said arithmetic decoding unit (11) decodes a code of the encoded moving picture, said symbol appearing probability control unit (12) is operable in parallel to calculate two kinds of renewed values for the set of the symbol value and the symbol appearing probability for the code, one of the two kinds of the renewed values being for a case when said arithmetic decoding unit (11) decodes a most probable symbol and the other of the two kinds of the renewed values being for a case when said arithmetic decoding unit (11) decodes a least probable symbol, and said symbol appearing probability control unit (12) is operable to select more suited one of the two kinds of the renewed values after said arithmetic decoding unit (11) determines the decoded symbol.

11. The arithmetic encoding/decoding device (40) as defined in claim 10, wherein said symbol appearing probability control unit (12) is operable to feed said arithmetic encoding unit (11) and said arithmetic decoding unit (11) the two kinds of the renewed values for the set of the symbol value and the symbol appearing probability,
wherein when said arithmetic encoding unit (11) arithmetic-encodes a moving picture signal with a same first context number, said arithmetic encoding unit (11) is operable, based on a symbol encoded immediately previously, to select more suited one of the two kinds of the renewed values, and
wherein when said arithmetic decoding unit (11) decodes an encoded moving picture with a same second context number, said arithmetic decoding unit (11) is operable, based on a symbol decoded immediately previously, to select more suited one of the two kinds of the renewed values.

12. The arithmetic encoding/decoding device (40) as defined in claim 9, wherein said probability state storing unit (13) is operable to store the symbol appearing probability in terms of a probability state number.

13. A portable terminal device comprising:
a receiver (515) operable to receive an encoded moving picture;
a moving picture expanding unit (513) comprising an arithmetic decoding device (514), said moving picture expanding unit (513) being operable to expand the encoded moving picture received by said receiver (515) to generate a display image; and
a picture display unit (512) operable to display the display image;
wherein said arithmetic decoding device (514) comprises:
an arithmetic decoding unit (11) operable to decode the encoded moving picture received by said receiver (515), thereby outputting a decoded symbol as a result of decoding;
a context calculating unit (20) operable to calculate a context number for the encoded moving picture, thereby feeding the calculated context number to said arithmetic decoding unit (11);
a symbol appearing probability control unit (12) operable to renew a set of a symbol value and a symbol appearing probability for one of a most probable symbol and a least probable symbol, based on the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic decoding unit (11) decodes an n-th code of the encoded moving picture, said context calculating unit (20) is operable in parallel to calculate the context number of an (n+1)-th code of the encoded moving picture, the (n+1)-th code being next to the n-th code, where n is a natural number.

14. A portable terminal device comprising:
a sender/receiver (515) operable to send and receive an encoded moving picture;
a camera (511) operable to shoot a moving picture, thereby feeding a moving picture signal;
a moving picture compressing/expanding unit (513) comprising an arithmetic encoding/decoding device (514), said moving picture compressing/expanding unit (513) being operable to process the moving picture signal fed by said camera (511) to generate an encoded moving picture to be sent by said sender/receiver (515), and said moving picture compressing/expanding unit (513) being further operable to process the encoded moving picture received by said sender/receiver (515) to generate a display image; and
a picture display unit (512) operable to display the moving picture shot by said camera (511) and the display image generated by said moving picture compressing/expanding unit (513),
wherein said arithmetic encoding/decoding device (514) comprises:
an arithmetic encoding unit (11) operable to arithmetic-encode the moving picture signal fed by said camera (511), thereby outputting an encoded symbol as a result of arithmetic encoding;
an arithmetic decoding unit (11) operable to decode the encoded moving picture received by said sender/receiver (515), thereby outputting a decoded symbol as a result of decoding;
a context calculating unit (20) operable to calculate a first context number for the moving picture signal, thereby feeding the first context number to said arithmetic encoding unit (11), and said context calculating unit (20) being further operable to calculate a second context number for the encoded moving picture, thereby feeding the second context number to said arithmetic decoding unit (11);
a symbol appearing probability control unit (12) operable to renew a set of a symbol value and a symbol appearing probability for one of a most probable symbol and a least probable symbol, based on one of the encoded symbol outputted by said arithmetic encoding unit (11) and the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes an m-th moving picture signal, said context calculating unit (20) is operable in parallel to calculate the first context number of an (m+1)-th moving picture signal, the (m+1)-th moving picture signal being next to the m-th moving picture signal, where m is a natural number; and
wherein, while said arithmetic decoding unit (11) decodes an n-th code of the encoded moving picture, said context calculating unit (20) is operable in parallel to calculate the second context number of an (n+1)-th code of the encoded moving picture, the (n+1)-th code being next to the n-th code, where n is a natural number.

15. A moving picture shooting device comprising:
a camera (511) operable to shoot a moving picture, thereby feeding a moving picture signal;
a recoding/replaying unit (520) operable to record and replay an encoded moving picture;
a moving picture compressing/expanding unit (513) comprising an arithmetic encoding/decoding device (514), said moving picture compressing/expanding unit (513) being operable to process the moving picture signal fed by said camera (511) to generate an encoded moving picture to be recorded by said recoding/replaying unit (520), and said moving picture compressing/expanding unit (513) being further operable to process the encoded moving picture replayed by said recoding/replaying unit (520) to generate a display image; and
a picture display unit (512) operable to display the moving picture shot by said camera (511) and the display image generated by said moving picture compressing/expanding unit (513),
wherein said arithmetic encoding/decoding device (514) comprises:
an arithmetic encoding unit (11) operable to arithmetic-encode the moving picture signal fed by said camera (511), thereby outputting an encoded symbol as a result of arithmetic encoding;
an arithmetic decoding unit (11) operable to decode the encoded moving picture replayed by said recoding/replaying unit (520), thereby outputting a decoded symbol as a result of decoding;
a context calculating unit (20) operable to calculate a first context number for the moving picture signal, thereby feeding the first context number to said arithmetic encoding unit (11), and said context calculating unit (20) being further operable to calculate a second context number for the encoded moving picture, thereby feeding the second context number to said arithmetic decoding unit (11);
a symbol appearing probability control unit (12) operable to renew a set of a symbol value and a symbol appearing probability for one of a most probable symbol and a least probable symbol, based on one of the encoded symbol outputted by said arithmetic encoding unit (11) and the decoded symbol outputted by said arithmetic decoding unit (11); and
a probability state storing unit (13) operable to store the set of the symbol value and the symbol appearing probability, the set being renewed by said symbol appearing probability control unit (12) and indexed with the context number,
wherein, while said arithmetic encoding unit (11) arithmetic-encodes an m-th moving picture signal, said context calculating unit (20) is operable in parallel to calculate the first context number of an (m+1)-th moving picture signal, the (m+1)-th moving picture signal being next to the m-th moving picture signal, where m is a natural number; and
wherein, while said arithmetic decoding unit (11) decodes an n-th code of the encoded moving picture, said context calculating unit (20) is operable in parallel to calculate the second context number of an (n+1)-th code of the encoded moving picture, the (n+1)-th code being next to the n-th code, where n is a natural number.

16. A moving picture recoding/replaying device comprising:
a moving picture input unit (531) operable to input a first moving picture signal;
a moving picture output unit (532) operable to output a second moving picture signal;
a recording/replaying unit (520) operable to record a first encoded moving picture and
replay a second encoded moving picture; and
a moving picture compressing/expanding unit (513) comprising an arithmetic encoding/decoding device (514), said moving picture compressing/expanding unit (513) being operable to process the first moving picture signal inputted by said moving picture input unit, thereby generating the first encoded moving picture to be recorded by said recoding/replaying unit (520), and said moving picture compressing/expanding unit (513) being further operable to process the second encoded moving picture replayed by said recoding/replaying unit (520), thereby generating the second moving picture signal to be outputted by said moving picture output unit (532),
wherein said arithmetic encoding/decoding device (514) comprises:
an arithmetic encoding unit (11) operable to arithmetic-encode the first moving picture signal inputted by said moving picture input unit (531), thereby outputting the first encoded symbol as a result of arithmetic encoding;
an arithmetic decoding unit (11) operable to decode the second encoded moving picture replayed by said recoding/replaying unit (520), thereby generating the second moving picture signal as a result of decoding;
a context calculating unit (20) operable to calculate a first context number for the first moving picture signal, thereby feeding the first context number to said arithmetic encoding unit (11), and said context calculating unit (20) being further operable to calculate a second context number for the second encoded moving picture, thereby feeding the second context number to said arithmetic decoding unit (11);
a symbol appearing probability control unit (12) operable to renew a set of a symbol value and a symbol appearing probability for one of a most probable symbol and a least probable symbol, based on one of the encoded symbol outputted by said arithmetic encoding unit (11) and the decoded symbol outputted by said arithmetic decoding unit (11); and
a probability state storing unit (13) operable to store the set of the symbol value and the symbol appearing probability, the set being renewed by said symbol appearing probability control unit (20) and indexed with the context number,
wherein, while said arithmetic encoding unit (11) arithmetic-encodes an m-th signal of the first moving picture signal, said context calculating unit (20) is operable in parallel to calculate the first context number for an (m+1)-th signal of the first moving picture signal, the (m+1)-th signal being next to the m-th signal, where m is a natural number; and
wherein, while said arithmetic decoding unit (11) decodes an n-th code of the second encoded moving picture, said context calculating unit (20) is operable in parallel to calculate the second context number of an (n+1)-th code of the second moving picture signal, the (n+1)-th code being next to the n-th code, where n is a natural number.
